# EUROPEAN PATENT SPECIFICATION

(11) **EP 3 087 621 B1**
(45) Date of publication and mention of the grant of the patent: **17.04.2019**
(21) Application number: 14819023.4
(22) Date of filing: 23.12.2014
(51) Int. Cl.: H01L 51/50, H01L 51/54

(54) **N-DOPED SEMICONDUCTING MATERIAL COMPRISING PHOSPHINE OXIDE MATRIX AND METAL DOPANT**
N-DOTIERTES HALBLEITERMATERIAL MIT PHOSPHINOXIDMATRIX UND METALLDOTIERMITTEL
MATÉRIAU SEMI-CONDUCTEUR DOPÉ AU N COMPRENANT UNE MATRICE OXYDE DE PHOSPHINE ET UN DOPANT MÉTALLIQUE

(30) Priority: 23.12.2013 EP 13199413; 05.06.2014 EP 14171326
(43) Date of publication of application: 02.11.2016
(73) Proprietor: Novaled GmbH, 01307 Dresden (DE)
(72) Inventor: ZÖLLNER, Mike, 01217 Dresden (DE); WERNER, Ansgar, 01277 Dresden (DE); ROSENOW, Thomas, 01069 Dresden (DE); ROTHE, Carsten, 01326 Dresden (DE); BIRNSTOCK, Jan, 01187 Dresden (DE); CANZLER, Tobias, 01099 Dresden (DE); DENKER, Ulrich, 01307 Dresden (DE); FADHEL, Omrane, 01099 Dresden (DE); BLOOM, Francisco, 5642 KZ Eindhoven (NL); KALISZ, Tomas, 01307 Dresden (DE); GILGE, Kai, 01097 Dresden (DE); ANGERMANN, Jens, 01328 Dresden (DE)
(74) Representative: Bittner, Thomas L.
(86) International application number: PCT/EP2014/079191
(87) International publication number: WO 2015/097232

(56) References cited:
- EP-A1- 3 079 179
- JP-A- 2006 073 581
- US-A- 6 013 384
- LINDA S. SAPOCHAK ET AL: "<title>Design strategies for achieving high triplet energy electron transporting host materials for blue electrophosphorescence</title>", PROCEEDINGS OF SPIE, vol. 6333, 31 August 2006 (2006-08-31), page 63330F, XP055186526, ISSN: 0277-786X, DOI: 10.1117/12.684126

## Description

The present invention concerns organic semiconducting material with improved electrical properties, process for its preparation, electronic device utilizing the improved electrical properties of the inventive semiconducting material, particularly the device comprising this organic semiconducting material in an electron transporting and/or electron injecting layer, and electron transport matrix compound applicable in semiconducting material of present invention.

### I. BACKGROUND OF THE INVENTION

Among the electronic devices comprising at least a part based on material provided by organic chemistry, organic light emitting diodes (OLEDs) have a prominent position. Since the demonstration of efficient OLEDs by Tang et al. in 1987 (C.W. Tang et al., Appl. Phys. Lett. 51 (12), 913 (1987)), OLEDs developed from promising candidates to high-end commercial displays. An OLED comprises a sequence of thin layers substantially made of organic materials. The layers typically have a thickness in the range of 1 nm to 5 µm. The layers are usually formed either by means of vacuum deposition or from a solution, for example by means of spin coating or jet printing.

OLEDs emit light after the injection of charge carriers in the form of electrons from the cathode and in form of holes from the anode into organic layers arranged in between. The charge carrier injection is effected on the basis of an applied external voltage, the subsequent formation of excitons in a light emitting zone and the radiative recombination of those excitons. At least one of the electrodes is transparent or semitransparent, in the majority of cases in the form of a transparent oxide, such as indium tin oxide (ITO), or a thin metal layer.

Among the matrix compounds used in OLED light emitting layers (LELs) or electron transporting layers (ETLs), important position have the compounds that comprise at least one phosphine oxide group. The reason why the phosphine oxide group often significantly improves the electron injecting and/or electron transporting properties of the semiconducting material is not yet fully understood. It is believed that the high dipole moment of the phosphine oxide group plays somehow the positive role. Especially recommended for this use are triaryl phosphine oxides comprising at least one condensed aromatic or heteroaromatic group attached directly to the phosphine oxide group, see e.g. JP 4 876 333 B2.

Electrical doping of charge transporting semiconducting materials for improving their electrical properties, especially conductivity, is known since nineties of the 20^{th} century, e.g. from US 5 093 698 A. An especially simple method for n-doping in ETLs prepared by the thermal vacuum deposition, which is currently the standard method most frequently used, e.g. in industrial manufacture of displays, is evaporation of a matrix compound from one evaporation source and of a highly electropositive metal from another evaporation source and their co-deposition on a solid substrate. As useful n-dopants in triaryl phosphine oxide matrix compounds, alkali metals and alkaline earth metals were recommended in JP 4 725 056 B2, with caesium as the dopant successfully used in the given examples. Indeed, caesium as the most electropositive metal offers the broadest freedom in the choice of a matrix material, and it is likely the reason why solely caesium was the n-doping metal of choice in the cited document.

For an industrial use, caesium as a dopant has several serious drawbacks. First, it is very reactive, moisture and highly air sensitive material that renders any handling difficult and incurs significant additional costs for mitigating the high safety and fire hazard unavoidably linked with its use. Second, its quite low normal boiling point (678 °C) indicates that it may be highly volatile under high vacuum conditions. Indeed, at pressures below 10⁻³ Pa used in industrial equipment for vacuum thermal evaporation (VTE), caesium metal evaporates significantly already at slightly elevated temperature. Taking into account that the evaporation temperatures for typical matrix compounds used in organic semiconducting materials at pressures below 10⁻³ Pa are typically between 150-400 °C, avoiding an uncontrolled caesium evaporation, resulting in its undesired deposition contaminating the colder parts of the whole equipment (e.g. the parts that are shielded against heat radiation from the organic matrix evaporation source), is a really challenging task.

Several methods for overcoming these drawbacks and enabling industrial applicability of caesium for n-doping in organic electronic devices have been published. For safe handling, caesium may be supplied in hermetic shells that open just inside the evacuated evaporation source, preferably during heating to the operational temperature. Such technical solution was provided e.g. in WO 2007/065685, however, it does not solve the problem of caesium high volatility.

US 7 507 694 B2 and EP 1 648 042 B1 offer another solution in form of caesium alloys that melt at low temperature and show significantly decreased caesium vapour pressure in comparison with the pure metal. Bismuth alloys of WO2007/109815 that release caesium vapours at pressures of the order 10⁻⁴ Pa and temperatures up to about 450 °C represent another alternative. Yet, all these alloys are still highly air and moisture sensitive. Moreover, this solution has further drawback in the fact that the vapour pressure over the alloy changes with the decreasing caesium concentration during the evaporation. That creates new problem of an appropriate deposition rate control, e.g. by programming the temperature of the evaporation source. So far, quality assurance (QA) concerns regarding robustness of such process on an industrial scale hamper a wider application of this technical solution in mass production processes.

A viable alternative to Cs doping represent highly electropositive transition metal complexes like W₂(hpp)₄ that have ionisation potentials comparably low as caesium and volatilities comparable with volatilities of usual organic matrices. Indeed, these complexes disclosed as electrical dopants first in WO2005/086251 are very efficient for most electron transporting matrices except some hydrocarbon matrices. Despite their high air and moisture sensitivity, these metal complexes provide satisfactory n-doping solution for an industrial use, if supplied in the shells according to WO 2007/065685. Its main disadvantage is their high price caused by relative chemical complexity of comprised ligands and necessity of a multistep synthesis of the final complex, as well as additional costs incurred by necessity of using the protective shells and/or by the QA and logistic issues linked with shell recycling and refilling.

Another alternative represent strong n-dopants created in situ in the doped matrix from relatively stable precursors by an additional energy supplied e.g. in form of ultraviolet (UV) or visible light of an appropriate wavelength. Appropriate compounds for this solution were provided e.g. in WO2007/107306 A1. Nevertheless, state-of-the-art industrial evaporation sources require materials with very high thermal stability, allowing their heating to the operational temperature of the evaporation source without any decomposition during the whole operating cycle (e.g., for a week at 300 °C) of the source loaded with the material to be evaporated. Providing organic n-dopants or n-dopant precursors with such long-term thermal stability is a real technical challenge so far. Moreover, the complicated arrangement of the production equipment that must ensure a defined and reproducible additional energy supply for achieving reproducibly the desired doping level (through the in situ activation of the dopant precursor deposited in the matrix) represents an additional technical challenge and a potential source of additional CA issues in mass production.

Yook et al (Advanced Functional Materials 2010, 20, 1797-1802) successfully used caesium azide in laboratory as an air-stable Cs precursor. This compound is known to decompose under heating above 300 °C to caesium metal and elemental nitrogen. This process is, however, hardly applicable in contemporary industrial VTE sources, due to difficult control of such decomposition reaction in a larger scale. Moreover, release of nitrogen gas as a byproduct in this reaction brings a high risk that especially at higher deposition rates desired in the mass production, the expanding gas will expel solid caesium azide particles from the evaporation source, causing thus high defect counts in the deposited layers of doped semiconducting materials.

Another alternative approach for electrical n-doping in electron transporting matrices is doping with metal salts or metal complexes. The most frequently used example of such dopant is lithium 8-hydroxy-quinolinolate (LiQ). It is especially advantageous in matrices comprising a phosphine oxide group, see e.g. WO 2012/173370 A2. The main disadvantage of metals salt dopants is that they improve basically only electron injection to the adjacent layers and do not increase the conductivity of doped layers. Their utilization for decreasing the operational voltage in electronic devices is thus limited on quite thin electron injecting or electron transporting layers and does hardly allow e.g. an optical cavity tuning by using ETLs thicker than approximately 25 nm, what is well possible with redox-doped ETLs having high conductivity. Furthermore, metal salts typically fail as electrical dopants in cases wherein creation of new charge carriers in the doped layer is crucial, e.g. in charge generating layers (CGL, called also p-n junctions) that are necessary for the function of tandem OLEDs.

For the above reasons, and especially for electrical doping in ETLs thicker than approximately 30 nm, the current technical practice prefers lithium as an industrial redox n-dopant (see e.g. US 6 013 384 B2). This metal is relatively cheap and differs from other alkali metals by its somewhat lower reactivity and, especially, by its significantly lower volatility (normal boiling point about 1340 °C), allowing its evaporation in the VTE equipment at temperatures between 350-550 °C.

Nevertheless, quite in accordance with its high n-doping power allowing Li to dope majority of usual types of electron transporting matrices, this metal possesses also a high degree of reactivity. It reacts under ambient temperature even with dry nitrogen and for its use in a highly reproducible manufacturing process complying with contemporary industrial QA standards, it must be stored and handled exclusively under high purity noble gases. Moreover, if Li is co-evaporated with matrix compounds that have evaporation temperatures in the range 150-300 °C, its significantly higher evaporation temperature in comparison with the matrix evaporation temperature already causes cross-contamination problems in the VTE equipment.

Many documents suggest as alternative n-dopants almost any known metallic element including weakly reductive and highly volatile Zn, Cd, Hg, weakly reductive Al, Ga, In, Tl, Bi, Sn, Pb, Fe, Co, Ni, or even noble metals like Ru, Rh, Ir and/or refractory metals with highest known boiling points like Mo, W, Nb, Zr (see e.g. JP 2009/076508 or WO 2009/106068). Unfortunately, not only in these two documents cited here as examples but throughout the scientific and patent literature overall, there is in fact lack of any evidence that some of these suggestions have ever been experimentally tested.

To be more specific, even WO 2009/106068 that does not merely mention all imaginable dopants but really strives to claim all the named metalloid elements as n-dopants in organic electronic devices due their alleged applicability through a high-temperature decomposition of a gaseous precursor compound in a heated nozzle, does not bring any single numeric value documenting the physical parameters of allegedly prepared doped materials and/or technical performance of allegedly prepared devices.

On the other hand, US2005/0042548 published before the date of priority of WO 2009/106068 teaches in paragraph 0069 (see namely the last two lines of the left column and first three lines of the right column on page 7) that iron pentacarbonyl can be used for n-doping in organic ETMs if the compound is activated by UV radiation which splits off a carbon monoxide ligand. The coordinatively unsaturated iron compound then reacts with the matrix, what results in the observed doping effects. In the light of this previous art showing that the metal carbonyls that were used in the alleged working example of WO 2009/106068 are known n-dopants in organic matrices if activated by supply of additional energy, it seems quite likely that if the applicants of WO2009/106068 really obtained with their jet of iron pentacarbonyl flowing through a ceramic nozzle electrically heated to a white glow (see the last paragraph of the German text on page 12 of the cited PCT application) any doping effect in the target bathocuproin layer, this effect was caused rather by the same coordinatively unsaturated iron carbonyl complex as produced by UV irradiation in US2005/0042548, than with elemental iron as they suggest. This suspicion is further supported by the fourth paragraph on page 13 of the cited PCT application which teaches that the same result can be obtained with a cold nozzle, if the stream of iron pentacarbonyl is irradiated with an infrared laser having the wavelength fitting with the absorption frequency of the CO groups in the iron pentacarbonyl complex. Here, it is even more likely that the laser activation resulted not in naked metal atoms or clusters of metal atoms but in a reactive coordinately unsaturated iron complex still bearing some carbonyl ligands, analogously to the reactive complex formed by activation with the UV light.

Despite metals with strongly negative standard redox potentials like alkali earth metals or lanthanides are recited as alternative n-dopants besides alkali metals basically in each document dealing with redox n-doping, the record of the proven n-doping with any metal different from alkali metals is very scarce.

Magnesium is in comparison with alkaline metals much less reactive. It reacts even with liquid water at the ordinary temperature very slowly and in air it keeps its metallic luster and does not gain weight for months. It may be thus considered as practically air-stable. Moreover, it has low normal boiling point (about 1100 °C), very promising for its VTE processing in an optimum temperature range for co-evaporation with organic matrices.

On the other hand, the authors of the present application confirmed in a screening done with dozens of state-of-the-art ETMs that Mg does not possess a sufficient doping strength for usual ETMs. The only favourable result has been achieved in OLEDs comprising thin electron injection layers consisting of a specific kind of triaryl phosphine oxide matrix (comprising a special tris-pyridyl unit designed for chelating metals), doped with magnesium, as shown in EP 2 452 946 A1. Despite the structural specifity and very favourable (in terms of its LUMO level which is quite deep under the vacuum level in the absolute energy scale) dopability of the exemplary matrix tested with magnesium in EP 2 452 946 A1, the positive results achieved with this n-doped semiconducting material encouraged further research focused on n-doping with substantially air stable metals.

Sapochak et al., Proceedings of Spie, 2006, 6333, 6330F discloses design strategies for achieving high triplet energy electron transporting host materials for blue electrophorescence.

US 6,013,384 A discloses organic electroluminescent devices.

JP 2006073581 A discloses light emitting devices and materials therefor.

EP 3 079 179 A1 discloses a semiconducting material comprising a phosphine oxide matrix and a metal salt.

It is an object of the invention to overcome the drawbacks of the prior art and to provide effectively n-doped semiconducting materials utilizing substantially air stable metals as n-dopants, especially in ETMs having their lowest unoccupied molecular orbital (LUMO) energy levels closer to vacuum level than the ETMs which have electrochemical redox potentials (that are in a simple linear relationship with the LUMO levels and are much easier measurable than LUMO levels themselves) with more negative values than about -2.25 V against ferrocenium/ferrocene reference.

It is a further object of the invention to provide alternative metallic elements which are substantially air stable and can be successfully embedded (preferably by standard VTE processes and using contemporary evaporation sources) in electrically doped semiconducting materials for use in electronic devices.

A third object of the invention is to provide a process for manufacturing the semiconducting material utilizing substantially air stable metals as n-dopants.

A fourth object of the invention is to provide devices with better characteristics, especially with low voltage and, more specifically, OLEDs with low voltage and high efficiency.

A fifth object of the invention is to provide new matrix compounds applicable in semiconducting materials according to the invention.

### II. SUMMARY OF THE INVENTION

The above objects are achieved in accordance with the subject-matter of the independent claims. Preferred embodiments result from the sub-claims.

The object is in particular achieved by an electrically doped semiconducting material comprising at least one metallic element in its substantially elemental form as n-dopant and at least one electron transport matrix compound comprising at least one phosphine oxide group, wherein the metallic element is selected from elements that form in their oxidation number II at least one stable compound and the electron transport matrix compound has the reduction potential, when measured by cyclic voltammetry under the same conditions, lower than tris(2-benzo[d]thiazol-2-yl)phenoxyaluminum, preferably lower than 9,9', 10,10'-tetraphenyl-2,2'-bianthracene or 2,9-di([1,1'-biphenyl]-4-yl)-4,7-diphenyl-1,10-phenanthroline, more preferably lower than 2,4,7,9-tetraphenyl-1,10-phenanthroline, even more preferably lower than 9,10-di(naphthalen-2-yl)-2-phenylanthracene, most preferably lower than 2,9-bis(2-methoxyphenyl)-4,7-dipbenyl-1,10-phenanthroline, still preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[ftuorene]-2,2',7,7'-tetraamine, preferably higher than triphenylene, more preferably higher than N4,N4'-di(naphthalen-1-yl)-N4,N4'-diphenyl-[1,1'-biphenyl]-4,4'-diamine, even more preferably higher than 4,4'-di(9H-carbazol-9-yl)-1,1'-biphenyl, most preferably higher than bis(4-(9H-carbazol-9-yl)phenyl)(phenyl)phosphine oxide, less but still preferably higher than 3-([1,1'-biphenyl]-4-yl)-5-(4-(tert-butyl)phenyl)-4-phenyl-4H-1,2,4-triazole and even less but still preferably higher than pyrene, wherein it is provided that the metallic element is not zinc.Under "stable compound", it is to be understood a compound that is, at the normal temperature 25 °C, thermodynamically and/or kinetically stable enough that it could be prepared and the oxidation state II for the metallic element could be proven.

It is preferred that the electron transport matrix compound is a compound according to formula (I): 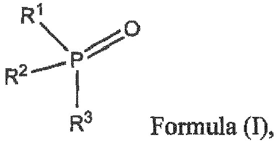 wherein R¹, R² and R³ are independently selected from C₁-C₃₀-alkyl, C₃-C₃₀ cycloalkyl, C₂-C₃₀-heteroalkyl, C₆-C₃₀-aryl, C₂-C₃₀-heteroaryl, C₁-C₃₀-alkoxy, C₃-C₃₀-cycloalkyloxy, C₆-C₃₀-aryloxy, wherein each of the substituents R¹, R² and R³ optionally comprises further phosphine oxide groups and at least one of the substituents R¹, R² and R³ comprises a conjugated system of at least 10 delocalized electrons.

Examples of conjugated systems of delocalized electrons are systems of alternating pi- and sigma bonds. Optionally, one or more two-atom structural units having the pi-bond between its atoms can be replaced by an atom bearing at least one lone electron pair, typically by a divalent atom selected from O, S, Se, Te or by a trivalent atom selected from N, P, As, Sb, Bi. Preferably, the conjugated system of delocalized electrons comprises at least one aromatic ring adhering to the Hückel rule. More preferably, the conjugated system of delocalized electrons comprises a condensed aromatic skeleton comprising at least 10 delocalized electrons, e.g. a naphthalene, anthracene, phenanthrene, pyrene, quinoline, indole or carbazole skeleton. Also preferably, the conjugated system of delocalized electrons may consist of at least two directly attached aromatic rings, the simplest examples of such systems being biphenyl, bithienyl, phenylthiophene, phenylpyridine and like.

Also preferably, the metallic element has the sum of its first and second ionization potential lower than 25 eV, more preferably lower than 24 eV, even more preferably lower than 23.5 eV, most preferably lower than 23.1 eV.

In one of preferred embodiments, the conjugated system of at least 10 delocalized electrons is attached directly to the phosphine oxide group.

In another preferred embodiment, the conjugated system of at least 10 delocalized electrons is separated from the phosphine oxide group by a spacer group A. The spacer group A is preferably a divalent six-membered aromatic carbocyclic or heterocyclic group, more preferably, the spacer group A is selected from phenylene, azine-2,4-diyl, azine-2,5-diyl, azine-2,6-diyl, 1,3-diazine-2,4-diyl and 1,3-diazine-2,5-diyl.

It is further preferred that the conjugated system of at least 10 delocalized electrons is a C₁₄-C₅₀-aryl or a C₈-C₅₀ heteroaryl.

In one of preferred embodiments, the electrically doped semiconducting material further comprises a metal salt additive consisting of at least one metal cation and at least one anion. Preferably, the metal cation is Li⁺ or Mg²⁺. Also preferably, the metal salt additive is selected from metal complexes comprising a 5-, 6- or 7- membered ring that contains a nitrogen atom and an oxygen atom attached to the metal cation and from complexes having the structure according to formula (II) 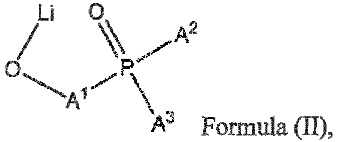 wherein A¹ is a C₆-C₃₀ arylene or C₂-C₃₀ heteroarylene comprising at least one atom selected from O, S and N in an aromatic ring and each of A² and A³ is independently selected from a C₆-C₃₀ aryl and C₂-C₃₀ heteroaryl comprising at least one atom selected from O, S and N in an aromatic ring. Equally preferably, the anion is selected from the group consisting of phenolate substituted with a phosphine oxide group, 8-hydroxyquinolinolate and pyrazolylborate. The metal salt additive preferably works as a second electrical n-dopant, more preferably, it works synergistically with the metallic element present in the elemental form and works as the first electrical n-dopant.

The second object of the invention is achieved by using a metal selected from Mg, Ca, Sr, Ba, Yb, Sm, Eu and Mn as an electrical n-dopant in any of electrically doped semiconducting materials defined above.

The third object of the invention is achieved by process for manufacturing the semiconducting material defined in any of claims 1-12, comprising a step where the electron transport matrix compound comprising at least one phosphine oxide group and the metallic element selected from elements that form in their oxidation number II at least one stable compound are coevaporated and codeposited under reduced pressure, wherein the electron transport matrix compound has a reduction potential, when measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, more preferably lower than 2,4,7,9-tetraphenyl-1,10-phenanthroline, even more preferably lower than 9,10-di(naphthalen-2-yl)-2-phenylanthracene, most preferably lower than 2,9-bis(2-methoxyphenyl)-4,7-diphenyl-1,10-phenanthroline, still preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than 4,4'-di(9H-carbazol-9-yl)-1,1'-biphenyl, even more preferably higher than bis(4-(9H-carbazol-9-yl)phenyl)(phenyl)phosphine oxide, most preferably higher than 3-([1,1'-biphenyl]-4-yl)-5-(4-(tert-butyl)phenyl)-4-phenyl-4H-1,2,4-triazole.Preferably, the metallic element has normal boiling point lower than 3000 °C, more preferably lower than 2200 °C, even more preferably lower than 1800 °C, most preferably lower than 1500°C. Under normal boiling point, it is to be understood the boiling point at normal atmospheric pressure (101.325 kPa). Also preferably, the metallic element has the sum of its first and second ionization potential higher than 16 eV, slightly more preferably higher than 17 eV, more preferably higher than 18 eV, even more preferably higher than 20 eV, most preferably higher than 21 eV, less but still preferably higher than 22 eV and even less but still preferably higher than 23 eV. It is preferred that the metallic element is substantially air stable. Preferably, the metallic element is selected from Mg, Ca, Sr, Ba, Yb, Sm, Eu and Mn, more preferably from Mg and Yb. Most preferably, the metallic element is Mg. Also preferably, the metallic element is evaporated from linear evaporation source. The first object of the invention is achieved also by electrically doped semiconducting material preparable by any of the above described processes according to invention.

The fourth object of the invention is achieved by electrically doped semiconducting material comprising at least one metallic element in its substantially elemental form as n-dopant and at least one electron transport matrix compound comprising at least one phosphine oxide group, wherein the metallic element is selected from elements that form in their oxidation number II at least one stable compound and the electron transport matrix compound has the reduction potential, when measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, more preferably lower than 2,4,7,9-tetraphenyl-1,10-phenanthroline, even more preferably lower than 9,10-di(naphthalen-2-yl)-2-phenylanthracene, most preferably lower than 2,9-bis(2-methoxyphenyl)-4,7-diphenyl-1,10-phenanthroline, still preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than N4,N4'-di(naphthalen-1-yl)-N4,N4'-diphenyl-[1,1'-biphenyl]-4,4'-diamine, even more preferably higher than 4,4'-di(9H-carbazol-9-yl)-1,1'-biphenyl, most preferably higher than bis(4-(9H-carbazol-9-yl)phenyl)(phenyl)phosphine oxide, less but still preferably higher than 3-([1,1'-biphenyl]-4-yl)-5-(4-(tert-butyl)phenyl)-4-phenyl-4H-1,2,4-triazole and even less but still preferably higher than pyrene, wherein it is provided that the metallic element is not zinc or preparable by a process recited above between the cathode and anode.

Preferred embodiments of the electronic device according to the invention comprise preferred embodiments of the inventive semiconducting material as recited above. More preferably, the preferred embodiments of the electronic device according to invention comprise the inventive semiconducting material prepared by any embodiment of the inventive process characterized above.

Preferably, the electrically doped semiconducting material forms an electron transporting or electron injecting layer. More preferably, the electron transporting or electron injecting layer is adjacent to a light emitting layer consisting of compounds that have their reduction potentials, if measured by cyclic voltammetry under the same conditions, lower than the electron transport matrix compounds of the adjacent electron transporting or electron injecting layer.

It is further preferred that the light emitting layer emits blue or white light. In one of preferred embodiments, the light emitting layer comprises at least one polymer. More preferably, the polymer is a blue light emitting polymer.

Also preferably, the electron transporting or electron injecting layer is thicker than 5 nm, preferably thicker than 10 nm, more preferably thicker than 15 nm, even more preferably thicker than 20 nm and most preferably thicker than 25 nm.

In one of preferred embodiments, the electron transporting or electron injecting layer is adjacent to a cathode consisting of a semiconducting metal oxide. Preferably, the semiconducting metal oxide is indium tin oxide. Also preferably, the cathode is prepared by sputtering.

Still another embodiment of the invention is a tandem OLED stack comprising a metal-doped pn-junction comprising a phosphine oxide electron transport matrix compound having its redox potential in the range specified above and a divalent metal.

The fifth object of the invention is achieved by compound selected from the group consisting of

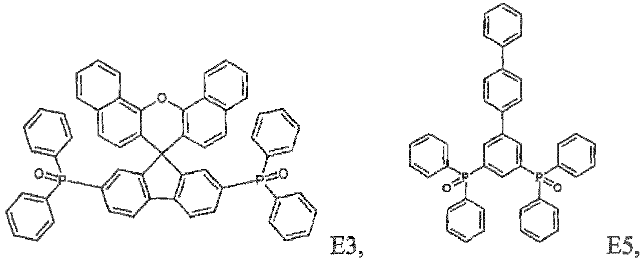

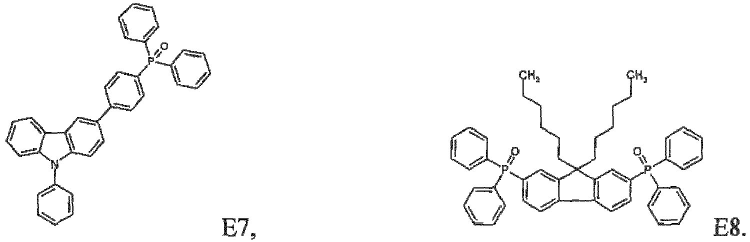

### III. BRIEF DESCRIPTION OF DRAWINGS

FIG. 1 shows a schematic illustration of a device in which the present invention can be incorporated.
FIG. 2 shows a schematic illustration of a device in which the present invention can be incorporated.

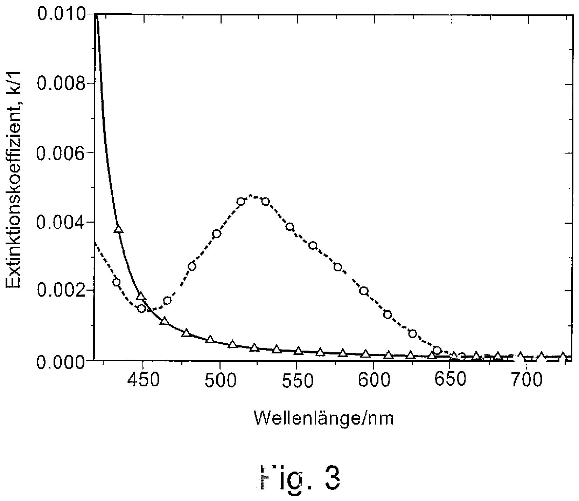

FIG. 3 shows absorbance curves of two n-doped semiconducting materials; circles stand for comparative matrix compound C10 doped with 10 wt% of compound F1 that forms strongly reducing radicals, triangles stand for compound E10 doped with 5 wt% Mg.

### IV. DETAILED DESCRIPTION OF THE INVENTION

### Device Architecture

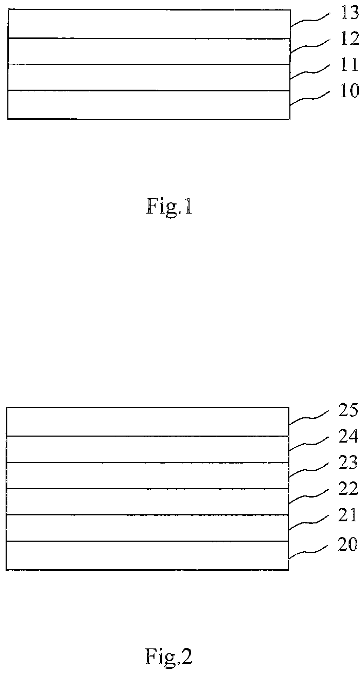

Fig. 1 shows a stack of anode (10), organic semiconducting layer (11) comprising the light emitting layer, electron transporting layer (ETL) (12), and cathode (13). Other layers can be inserted between those depicted, as explained herein.

Fig. 2 shows a stack of an anode (20), a hole injecting and transporting layer (21), a hole transporting layer (22) which can also aggregate the function of electron blocking, a light emitting layer (23), an ETL (24), and a cathode (25). Other layers can be inserted between those depicted, as explained herein.

The wording "device" comprises the organic light emitting diode.

### Material properties - energy levels

A method to determine the ionization potentials (IP) is the ultraviolet photo spectroscopy (UPS). It is usual to measure the ionization potential for solid state materials; however, it is also possible to measure the IP in the gas phase. Both values are differentiated by their solid state effects, which are, for example the polarization energy of the holes that are created during the photo ionization process. A typical value for the polarization energy is approximately 1 eV, but larger discrepancies of the values can also occur. The IP is related to onset of the photoemission spectra in the region of the large kinetic energy of the photoelectrons, i.e. the energy of the most weakly bounded electrons. A related method to UPS, the inverted photo electron spectroscopy (IPES) can be used to determine the electron affinity (EA). However, this method is less common. Electrochemical measurements in solution are an alternative to the determination of solid state oxidation (Eₒₓ) and reduction (E_{red}) potential. An adequate method is, for example, cyclic voltammetry. To avoid confusion, the claimed energy levels are defined in terms of comparison with reference compounds having well defined redox potentials in cyclic voltammetry, when measured by a standardized procedure. A simple rule is very often used for the conversion of redox potentials into electron affinities and ionization potential: IP (in eV) = 4.8 eV + e*Eₒₓ (wherein Eₒₓ is given in volts vs. ferrocenium/ferrocene (Fc⁺/Fc)) and EA (in eV) = 4.8 eV + e*E_{red} (E_{red} is given in volts vs. Fc⁺/Fc) respectively (see B.W. D'Andrade, Org. Electron. 6, 11-20 (2005)), e* is the elemental charge. Conversion factors for recalculation of the electrochemical potentials in the case other reference electrodes or other reference redox pairs are known (see A.J. Bard, L.R. Faulkner, "Electrochemical Methods: Fundamentals and Applications", Wiley, 2. Ausgabe 2000). The information about the influence of the solution used can be found in N.G. Connelly et al., Chem. Rev. 96, 877 (1996). It is usual, even if not exactly correct, to use the terms "energy of the HOMO" E_{(HOMO)} and "energy of the LUMO" E_{(LUMO)}, respectively, as synonyms for the ionization energy and electron affinity (Koopmans Theorem). It has to be taken into consideration that the ionization potentials and the electron affinities are usually reported in such a way that a larger value represents a stronger binding of a released or of an absorbed electron, respectively. The energy scale of the frontier molecular orbitals (HOMO, LUMO) is opposed to this. Therefore, in a rough approximation, the following equations are valid: IP = -E_{(HOMO)} and EA = E_{(LUMO)} (the zero energy is assigned to the vacuum).

For the chosen reference compounds, the inventors obtained following values of the reduction potential by standardized cyclic voltammetry in tetrahydrofuran (THF) solution vs. Fc⁺/Fc: 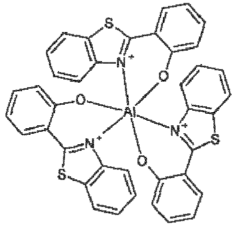 tris(2-benzo[d]thiazol-2-yl)phenoxyaluminum, CAS 1269508-14-6, -2.21 V, B0; 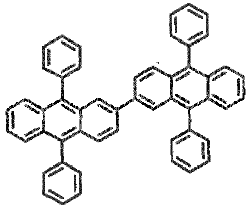 9,9',10,10'-tetraphenyl-2,2'-bianthracene (TPBA), CAS 172285-72-2, -2.28 V, B1; 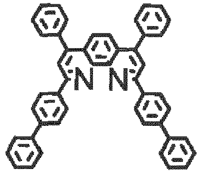 2,9-di([1,1'-biphenyl]-4-yl)-4,7-diphenyl-1,10-phenanthroline, CAS 338734-83-1, -2.29 V, B2; 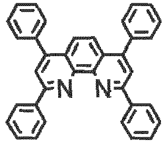 2,4,7,9-tetraphenyl-1,10-phenanthroline, CAS 51786-73-3, -2.33 V, B3; 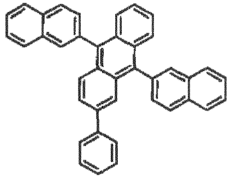 9,10-di(naphthalen-2-yl)-2-phenylanthracene (PADN), CAS 865435-20-7, -2.37 V, B4; 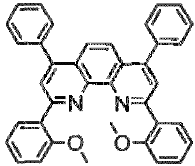 2,9-bis(2-methoxyphenyl)-4,7-diphenyl-1,1O-phenanthroline, CAS 553677-79-5, -2.40 V, B5; 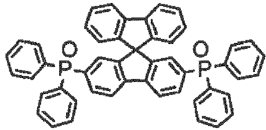 9,9'-spirobi[fluorene]-2,7-diylbis(diphenylphosphine oxide) (SPPO13), CAS 1234510-13-4, -2.41 V, B6; 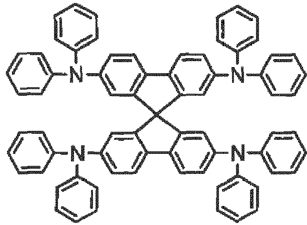 N2,N2,N2',N2',N7,N7,N7,N7'-octaphenyl-9,9'-spirobi[fluorene]-2,2',7,7'-tetraamine (Spiro TAD), CAS 189363-47-1, -3.10 V. B7; 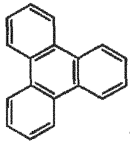 triphenylene, CAS 217-59-4, -3.04 V, B8; 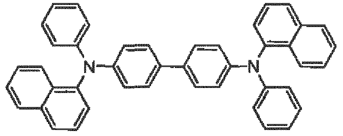 N4,N4'-di(naphthalen-1-yl)-N4,N4'-diphenyl-[1,1'-biphenyl]-4,4'-diamine (alpha-NPD), CAS 123847-85-8, -2.96 V, B9; 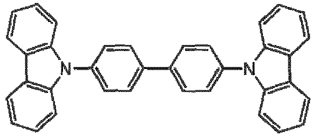 4,4'-di(9H-carbazol-9-yl)-1,1'-biphenyl (CBP), CAS 58328-31-7, -2.91 V, B10; 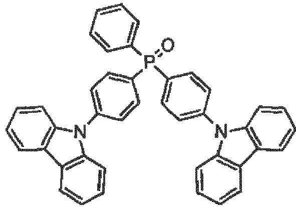 bis(4-(9H-carbazol-9-yl)phenyl)(phenyl)phosphine oxide (BCPO), CAS 1233407-28-7, -2.86, B11; 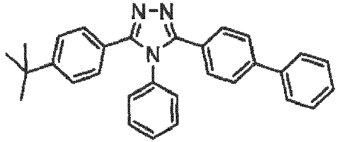 3-([1,1'-biphenyl]-4-yl)-5-(4-(tert-butyl)phenyl)-4-phenyl-4H-1,2,4-triazole (TAZ), -2.76 V, B12; 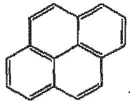 pyrene, CAS 129-00-0, -2.64 V, B13.

Examples of matrix compounds for the inventive electrically doped semiconducting materials are 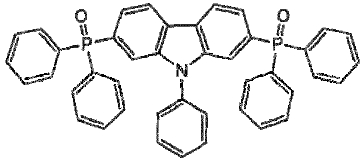 (9-phenyl-9H-carbazole-2,7-diyl)bis(diphenylphosphine oxide) (PPO27), CAS 1299463-56-1, -2.51 V, E1; 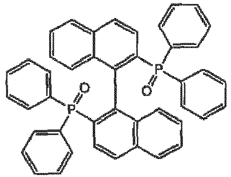 [1,1'-binaphthalen]-2,2'-diylbis(diphenylphosphine oxide) (BINAPO), CAS 86632-33-9, -2.69 V, E2; 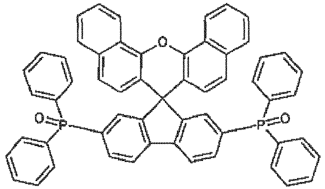 spiro[dibenzo[c,h]xanthene-7,9'-fluorene]-2',7-diylbis(diphenylphosphine oxide), -2.36 V, E3; 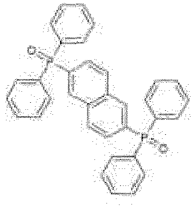 naphtalene-2,6-diylbis(diphenylphosphine oxide), -2.41 V, E4; 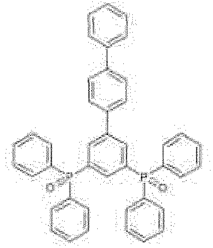 [1,1': 4,1"-terphenyl]-3,5-diylbis(diphenylphosphine oxide), -2.58 V, E5; 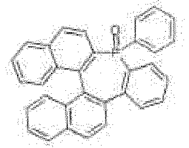 3-phenyl-3H-benzo[b]dinaphto[2,1-d:1',2'-f]phosphepine-3-oxide, CAS 597578-38-6, -2.62 V, E6; 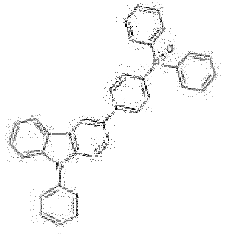 diphenyl(4-(9-phenyl-9H-carbazol-3 -yl)phenylphosphine oxide, -2.81 V, E7; 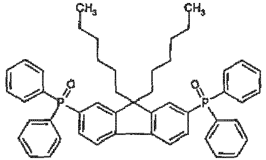 (9,9-dihexyl-9H-fluorene-2,7-diyl)bis(diphenylphosphine oxide), -2.52 V, E8; 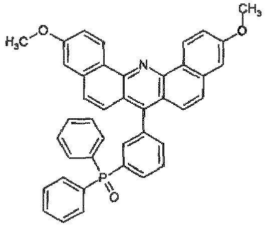 (3-(3,11-dimethoxydibenzo[c,h]acridin-7-yl)phenyl)diphenylphosphine oxide (described in WO2013/079217 A1), -2.29 V. E9; 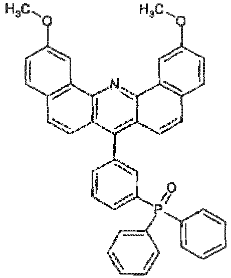 (3-(2,12-dimethoxydibenzo[c,h]acridin-7-yl)phenyl)diphenylphosphine oxide (described in WO2013/079217 A1), -2.24 V, E10; 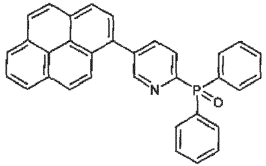 diphenyl(5-(pyren-1-yl)pyridine-2-yl)phosphine oxide, described in WO2014/167020, -2.34 V, E11; 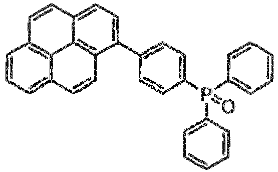 diphenyl(4-(pyren-1-yl)phenyl)phosphine oxide, described in PCT/EP2014/071659, -2.43 V, E12.

Preferred matrix compounds for semiconducting materials of present invention are compounds E1, E2, E5, E6, E8.

As comparative compounds were used 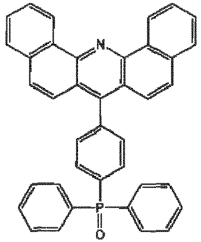 (4-(dibenzo[c,h]acridin-7-yl)phenyl)diphenylphosphine oxide (described in WO2011/154131 A1), -2.20 V, C1; 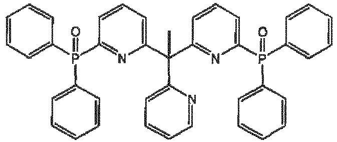 (6,6'-(1-(pyridin-2-yl)ethane-1,1-diyl)bis(pyridine-6,2-diyl))bis(diphenylphosphine oxide), described in EP 2 452 946, -2.21 V, C2; 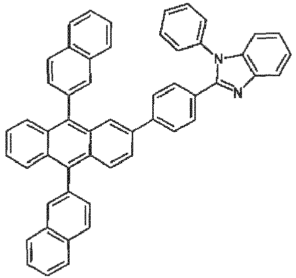 2-(4-(9,10-di(naphthalen-2-yl)anthracen-2-yl)phenyl)-1-phenyl-1H-benzo[d]imidazole, CAS 561064-11-7, -2.32 V, C3; 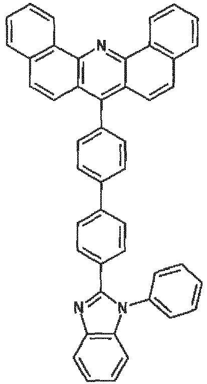 7-(4'-(1-phenyl-1H-benzo[d]imidazol-2-yl-[1,1-biphenyl]-4-yl)dibenzo[c,h]acridine (described in WO2011/154131 A1), -2.24 V, C4; 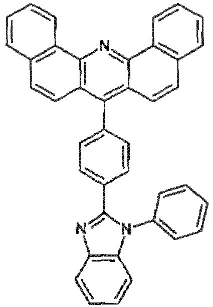 7-(4'-(1-phenyl-1H-benzo[d]imidazol-2-yl)phenyl)dibenzo[c,h]acridine (described in WO2011/154131 A1), -2.22 V. C5; 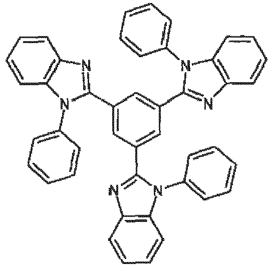 1,3,5-tris(1-phenyl-1H-benzimidazol-2-yl)benzene (TPBI) CAS 192198-85-9, -2.58 V, C6; 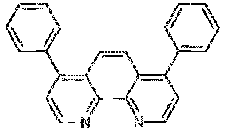 4,7-diphenyl-1,10-phenanthroline (Bphen) CAS 1662-01-7, - 2.47 V, C7; 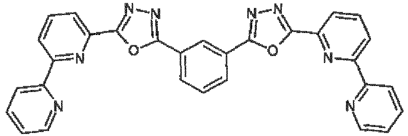 1,3-bis[2-(2,2'-bipyridine-6-yl)-1,3,4-oxadiazol-5-yl]benzene (Bpy-OXD), -2.28 V, C8; 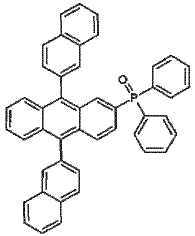 (9,10-di(naphthalen-2-yl)anthracen-2-yl)diphenylphosphine oxide, CAS 1416242-45-9, -2.19 V, C9; 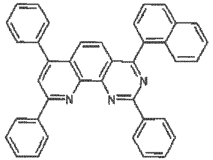 4-(naphtalen-1-yl)-2,7,9-triphenylpyrido[3,2-h]quinazoline, according to EP 1 971 371, -2.18 V, C10.

### Substrate

It can be flexible or rigid, transparent, opaque, reflective, or translucent. The substrate should be transparent or translucent if the light generated by the OLED is to be transmitted through the substrate (bottom emitting). The substrate may be opaque if the light generated by the OLED is to be emitted in the direction opposite of the substrate, the so called top-emitting type. The OLED can also be transparent. The substrate can be either arranged adjacent to the cathode or anode.

### Electrodes

The electrodes are the anode and the cathode, they must provide a certain amount of conductivity, being preferentially conductors. Preferentially the "first electrode" is the cathode. At least one of the electrodes must be semi-transparent or transparent to enable the light transmission to the outside of the device. Typical electrodes are layers or a stack of layer, comprising metal and/or transparent conductive oxide. Other possible electrodes are made of thin busbars (e.g. a thin metal grid) wherein the space between the busbars is filled (coated) with a transparent material having certain conductivity, such as graphene, carbon nanotubes, doped organic semiconductors, etc.

In one embodiment, the anode is the electrode closest to the substrate, which is called non-inverted structure. In another mode, the cathode is the electrode closest to the substrate, which is called inverted structure.

Typical materials for the Anode are ITO and Ag. Typical materials for the cathode are Mg:Ag (10 vol% of Mg), Ag, ITO, Al. Mixtures and multilayer are also possible.

Preferably, the cathode comprises a metal selected from Ag, Al, Mg, Ba, Ca, Yb, In, Zn, Sn, Sm, Bi, Eu, Li, more preferably from Al, Mg, Ca, Ba and even more preferably selected from Al or Mg. Preferred is also a cathode comprising an alloy of Mg and Ag.

It is one of the advantages of the present invention that it allows broad selection of cathode materials, besides metals with low work function also other metals or conductive metal oxides may be used as cathode materials. It is equally well possible that the cathode is pre-formed on a substrate (then the device is an inverted device), or the cathode in a non-inverted device is formed by vacuum deposition of a metal or by sputtering.

### Hole-Transporting Layer (HTL)

The HTL is a layer comprising a large gap semiconductor responsible to transport holes from the anode or holes from a CGL to the light emitting layer (LEL). The HTL is comprised between the anode and the LEL or between the hole generating side of a CGL and the LEL. The HTL can be mixed with another material, for example a p-dopant, in which case it is said the HTL is p-doped. The HTL can be comprised by several layers, which can have different compositions. P-doping of the HTL lowers its resistivity and avoids the respective power loss due to the otherwise high resistivity of the undoped semiconductor. The doped HTL can also be used as optical spacer, because it can be made very thick, up to 1000 nm or more without significant increase in resistivity.

Suitable hole transport matrices (HTM) can be, for instance compounds from the diamine class, where a delocalized pi-electron system conjugated with lone electron pairs on the nitrogen atoms is provided at least between the two nitrogen atoms of the diamine molecule. Examples are N4,N4'-di(naphthalen-1-yl)-N4,N4'-diphenyl-[1,1'-biphenyl]-4,4'-diamine (HTM1), N4,N4, N4",N4"-tetra([1,1'-biphenyl]-4-yl)-[1,1':4',1"-terphenyl]-4,4"-diamine (HTM2). The synthesis of diamines is well described in literature; many diamine HTMs are readily commercially available.

### Hole-Injecting Layer (HIL)

The HIL is a layer which facilitates the injection of holes from the anode or from the hole generating side of a CGL into an adjacent HTL. Typically, the HIL is a very thin layer (<10 nm). The hole injection layer can be a pure layer of p-dopant and can be about 1 nm thick. When the HTL is doped, an HIL may not be necessary, since the injection function is already provided by the HTL.

### Light-Emitting Layer (LEL)

The light emitting layer must comprise at least one emission material and can optionally comprise additional layers. If the LEL comprises a mixture of two or more materials the charge carrier injection can occur in different materials for instance in a material which is not the emitter, or the charge carrier injection can also occur directly into the emitter. Many different energy transfer processes can occur inside the LEL or adjacent LELs leading to different types of emission. For instance excitons can be formed in a host material and then be transferred as singlet or triplet excitons to an emitter material which can be singlet or triplet emitter which then emits light. A mixture of different types of emitter can be provided for higher efficiency. White light can be realized by using emission from an emitter host and an emitter dopant. In one of preferred embodiments of the invention, the light emitting layer comprises at least one polymer.

Blocking layers can be used to improve the confinement of charge carriers in the LEL, these blocking layers are further explained in US 7,074,500 B2.

### Electron-Transporting Layer (ETL)

The ETL is a layer comprising a large gap semiconductor responsible for electron transport from the cathode or electrons from a CGL or EIL (see below) to the LEL. The ETL is comprised between the cathode and the LEL or between the electron generating side of a CGL and the LEL. The ETL can be mixed with an electrical n-dopant, in which case it is said the ETL is n-doped. The ETL can be comprised by several layers, which can have different compositions. Electrical n-doping the ETL lowers its resistivity and/or improves its ability to inject electrons into an adjacent layer and avoids the respective power loss due to the otherwise high resistivity (and/or bad injection ability) of the undoped semiconductor. If the used electrical doping creates new charge carriers in the extent that substantially increases conductivity of the doped semiconducting material in comparison with the undoped ETM, then the doped ETL can also be used as optical spacer, because it can be made very thick, up to 1000 nm or more without significant increase in the operational voltage of the device comprising such doped ETL. The preferable mode of electrical doping that is supposed to create new charge carriers is so called redox doping. In case of n-doping, the redox doping corresponds to the transfer of an electron from the dopant to a matrix molecule.

In case of electrical n-doping with metals used as dopants in their substantially elemental form, it is supposed that the electron transfer from the metal atom to the matrix molecule results in a metal cation and an anion radical of the matrix molecule. Hopping of the single electron from the anion radical to an adjacent neutral matrix molecule is the currently supposed mechanism of charge transport in redox n-doped semiconductors.

It is, however, hard to understand all properties of semiconductors n-doped with metals and, specifically, of semiconducting materials of present invention, in terms of electrical redox doping. It is therefore supposed that semiconducting materials of present invention advantageously combine redox doping with yet unknown favourable effects of mixing ETMs with metal atoms and/or their clusters. It is supposed that semiconducting materials of present invention contain a significant part of the added metallic element in its substantially elemental form. The term "substantially elemental" shall be understood as a form that is, in terms of electronic states and their energies, closer to the state of a free atom or to the state of a cluster of metal atoms than to the state of a metal cation or to the state of a positively charged cluster of metal atoms.

Without being limited by theory, it can be supposed that there is an important difference between the n-doped organic semiconducting materials of previous art and the n-doped semiconducting materials of the present invention. The strong redox n-dopants like alkali metals or W₂(hpp)₄ of previous art are supposed to create in common organic ETMs (having reduction potentials roughly in the range between -2.0 and -3.0 V vs. Fc⁺/Fc) the amounts of charge carriers that are commensurate to the number of individual atoms or molecules of the added dopant, and there is indeed an experience that increasing the amount of such strong dopant in the chosen matrix above certain level does not bring any substantial gain in electrical properties of the doped material.

On the other hand, the weaker dopants of the present invention behave quite different in matrices comprising phosphine oxide groups, especially in those having deeper LUMO levels in the absolute scale, corresponding to the reduction potentials vs. Fc⁺/Fc roughly in the range between -2.3 and -2.8 V. They seem to work partially also by "classical" redox mechanism improving the amount of free charge carriers, but in a manner that is less tightly linked with the dopant amount.

In other words, it is supposed that in ETMs with deeper LUMO that are specially appropriate for white or blue OLEDs, due their reduction potentials vs. Fc⁺/Fc roughly in the range between -2.3 and -2.8 V, only part of added atoms of the metallic element added as the n-dopant reacts with matrix molecules by the redox mechanism under formation corresponding metal cations. It is rather supposed that even in high dilution, when the amount of the matrix is substantially higher than the amount of added metallic element, a substantial part of the metallic element is present in a substantially elemental form. It is further supposed that if the metallic element of the present invention is mixed with matrix of the present invention in a comparable amount, the majority of the added metallic element is present in the resulting doped semiconducting material in the substantially elemental form. This hypothesis seems to provide a reasonable explanation as to why the metallic elements of the present invention can be effectively used in significantly broader range of ratios to the doped matrix than the stronger dopants of previous art, even though they are weaker dopants. The applicable content of the metallic element in the doped semiconducting material of the present invention is roughly in the range from 0.5 weight % up to 25 weight %, preferably in the range from 1 to 20 weight %, more preferably in the range from 2 to 15 weight %, most preferably in the range from 3 to 10 weight %. Despite measurement of optical properties of the thin layers used in present OLEDs and their changes caused by doping is a challenging task having many technical obstacles, the ellipsometric measurements performed by authors seem to support the hypothesis presented above. In comparison with ETMs doped with strongly reducing alkali metals, like Li, metal complexes like W₂(hpp)₄ or with in situ generated strongly reducing radicals of WO2007/107306, the doped layers comprising semiconducting material of present invention show lower optical absorption, particularly at high dopant amounts. Quite surprisingly, the same seems to apply also for typically trivalent metals like Al that was found to perform poorly in ETMs comprising at least one phosphine oxide group, despite its ionization potentials being comparable to metallic elements useful as dopants in the present invention. It seems rather likely that favourable effects observed in phosphine oxide ETMs doped with metallic elements of the present invention are to be assigned to a yet unknown interaction of the phosphine oxide group with divalent metals, which is either impossible or significantly weaker in metals that are not able to form stable compounds in oxidation state two.

Hole blocking layers and electron blocking layers can be employed as usual.

In one mode of the invention the ETL comprises 2 zones, the first zone which is closer to LEL and the second zone which is closer to the cathode. In one of preferred embodiments, the first zone comprises a first ETM and the second zone a second ETM. More preferably, the LUMO level of the first ETM is, in comparison with the LUMO level of the second ETM, closer to the LUMO level of the emitter host that forms basis of the LEL. Also preferably, the first zone comprises only the ETM and is not electrically doped. In another preferred embodiment, the second zone comprises, besides the metallic element that acts as the first electrical dopant, also a second electrical dopant. More preferably, the second electrical dopant is a metal salt comprising at least one anion and at least one cation. In another embodiment, a metal salt is comprised in both first and second zones. In yet another embodiment, the metal salt is preferably comprised in the first zone, whereas the metallic element is preferably comprised in the second zone. In a preferred embodiment, the first and second zone are adjacent each other. Also preferably, the first zone is adjacent to the LEL. Also preferably, the first zone may be adjacent to the cathode.

Optionally, both the first and second zones comprise the same ETM.

Other layers with different functions can be included, and the device architecture can be adapted as known by the skilled in the art. For example, an Electron-Injecting Layer (EIL) made of metal, metal complex or metal salt can be used between the cathode and the ETL.

### Charge generation layer (CGL)

The OLED can comprise a CGL which can be used in conjunction with an electrode as inversion contact, or as connecting unit in stacked OLEDs. A CGL can have the most different configurations and names, examples are pn-junction, connecting unit, tunnel junction, etc. Best examples are pn-junctions as disclosed in US 2009/0045728 A1, US 2010/0288362 A1. Metal layers and or insulating layers can also be used.

### Stacked OLEDs

When the OLED comprises two or more LELs separated by CGLs, the OLED is called a stacked OLED, otherwise it is called a single unit OLED. The group of layers between two closest CGLs or between one of the electrodes and the closest CGL is called a electroluminescent unit (ELU). Therefore, a stacked OLED can be described as anode/ELU₁/{CGL_{X}/ELU_{1+X}}_{X}/cathode, wherein x is a positive integer and each CGL_{X} or each ELU_{1+X} can be equal or different. The CGL can also be formed by the adjacent layers of two ELUs as disclosed in US2009/0009072 A1. Further stacked OLEDs are described e.g. in US 2009/0045728 A1, US 2010/0288362 A1, and references therein.

### Deposition of Organic Layers

Any organic semiconducting layers of the inventive display can be deposited by known techniques, such as vacuum thermal evaporation (VTE), organic vapour phase deposition, laser induced thermal transfer, spin coating, blade coating, slot dye coating, inkjet printing, etc. A preferred method for preparing the OLED according to the invention is vacuum thermal evaporation. Polymeric materials are preferably processed by coating techniques from solutions in appropriate solvents.

Preferably, the ETL is formed by evaporation. When using an additional material in the ETL, it is preferred that the ETL is formed by co-evaporation of the electron transporting matrix (ETM) and the additional material. The additional material may be mixed homogeneously in the ETL. In one mode of the invention, the additional material has a concentration variation in the ETL, wherein the concentration changes in the direction of the thickness of the stack of layers. It is also foreseen that the ETL is structured in sub-layers, wherein some but not all of these sub-layers comprise the additional material.

### Electrical doping

The most reliable and, at the same time, efficient OLEDs are OLEDs comprising electrically doped layers. Generally, the electrical doping means improving of electrical properties, especially the conductivity and/or injection ability of a doped layer in comparison with neat charge-transporting matrix without a dopant. In the narrower sense, which is usually called redox doping or charge transfer doping, hole transport layers are doped with a suitable acceptor material (p-doping) or electron transport layers with a donor material (n-doping), respectively. Through redox doping, the density of charge carriers in organic solids (and therefore the conductivity) can be increased substantially. In other words, the redox doping increases the density of charge carriers of a semiconducting matrix in comparison with the charge carrier density of the undoped matrix. The use of doped charge-carrier transport layers (p-doping of the hole transport layer by admixture of acceptor-like molecules, n-doping of the electron transport layer by admixture of donor-like molecules) in organic light-emitting diodes is, e.g., described in US 2008/203406 and US 5,093,698.

US2008227979 discloses in detail the charge-transfer doping of organic transport materials, with inorganic and with organic dopants. Basically, an effective electron transfer occurs from the dopant to the matrix increasing the Fermi level of the matrix. For an efficient transfer in a p-doping case, the LUMO energy level of the dopant is preferably more negative than the HOMO energy level of the matrix or at least not more than slightly more positive, preferably not more than 0.5 eV more positive than the HOMO energy level of the matrix. For the n-doping case, the HOMO energy level of the dopant is preferably more positive than the LUMO energy level of the matrix or at least not more than slightly more negative, preferably not more than 0.5 eV lower compared to the LUMO energy level of the matrix. It is furthermore desired that the energy level difference for energy transfer from dopant to matrix is smaller than + 0.3 eV.

Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalene-2,6-diylidene) dimalononitrile (PD1). α-NPD doped with 2,2',2"-(cyclopropane-1,2,3-triylidene)tris(2-(p-cyanotetrafluorophenyl)acetonitrile) (PD2). All p-doping in the device examples of the present application was done with 3 mol% of PD2.

Typical examples of known redox doped electron transport materials are: fullerene C60 doped with acridine orange base (AOB); perylene-3,4,9,10-tetracarboxylic-3,4,9,10-dianhydride (PTCDA) doped with leuco crystal violet; 2,9 - di (phenanthren-9-yl) - 4,7 - diphenyl - 1,10 - phenanthroline doped with tetrakis (1,3,4,6,7,8 - hexahydro - 2H - pyrimido [1,2 - a] pyrimidinato) ditungsten (II) (W₂(hpp)₄); naphthalene tetracarboxylic acid di-anhydride (NTCDA) doped with 3,6-bis-(dimethyl amino)-acridine; NTCDA doped with bis(ethylene-dithio) tetrathiafulvalene (BEDT-TTF).

In the present invention, it was surprisingly found that classical redox dopants with high reduction strength, expressed as a highly negative redox potential measured by cyclic voltammetry (CV) in THF vs. Fc+/Fc standard, are not necessarily the best n-dopants in organic electron transport matrices. Specifically, it was surprisingly found that in ETMs bearing at least one phosphine oxide group, divalent metals are superior as n-dopants over alkali metals or organic metal complexes like W₂(hpp)₄, despite their electrochemical redox potentials are significantly less negative in comparison with alkali metals or complexes like W₂(hpp)₄. Even more surprisingly, it was found that the advantage of divalent metals is more pronounced in ETMs having their redox potentials more negative than about -2.25 V vs Fc⁺/Fc.

Besides the redox dopants, certain metal salts can be alternatively used for electrical n-doping resulting in lowering operational voltage in devices comprising the doped layers in comparison with the same device without metal salt. True mechanism how these metal salts, sometimes called "electrically doping additives", contribute to the lowering of the voltage in electronic devices, is not yet known. It is believed that they change potential barriers on the interfaces between adjacent layers rather than conductivities of the doped layers, because their positive effect on operational voltages is achieved only if layers doped with these additives are very thin. Usually, the electrically undoped or additive doped layers are thinner than 50 nm, preferably thinner than 40 nm, more preferably thinner than 30 nm, even more preferably thinner than 20 nm, most preferably thinner than 15 nm. If the manufacturing process is precise enough, the additive doped layers can be advantageously made thinner than 10 nm or even thinner than 5 nm.

Typical representatives of metal salts which are effective as second electrical dopants in the present invention are salts comprising metal cations bearing one or two elementary charges. Favourably, salts of alkali metals or alkaline earth metals are used. The anion of the salt is preferably an anion providing the salt with sufficient volatility, allowing its deposition under high vacuum conditions, especially in the temperature and pressure range which is comparable with the temperature and pressure range suitable for the deposition of the electron transporting matrix.

Example of such anion is 8-hydroxyquinolinolate anion. Its metal salts, for example lithium 8-hydroxyquinolinolate (LiQ) represented by the formula D1 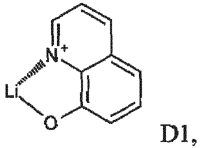 are well known as electrically doping additives.

Another class of metal salts useful as electrical dopants in electron transporting matrices of the present invention represent compounds disclosed in the application PCT/EP2012/074127 (WO2013/079678), having general formula (II) 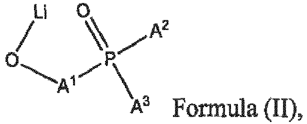 wherein A¹ is a C₆-C₂₀ arylene and each of A²-A³ is independently selected from a C₆-C₂₀ aryl, wherein the aryl or arylene may be unsubstituted or substituted with groups comprising C and H or with a further LiO group, provided that the given C count in an aryl or arylene group includes also all substituents present on the said group. It is to be understood that the term substituted or unsubstituted arylene stands for a divalent radical derived from substituted or unsubstituted arene, wherein the both adjacent structural moieties (in formula (I), the OLi group and the diaryl prosphine oxide group) are attached directly to an aromatic ring of the arylene group. In examples of the present application, this class of dopants is represented by compound D2 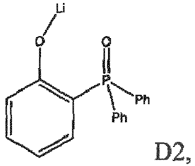 wherein Ph is phenyl.

Yet another class of metal salts useful as electrical dopants in electron transporting matrices of the present invention represent compounds disclosed in the application PCT/EP2012/074125 (WO2013/079676), having general formula (III) 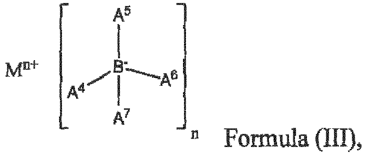 wherein M is a metal ion, each of A⁴- A⁷ is independently selected from H, substituted or unsubstituted C₆-C₂₀ aryl and substituted or unsubstituted C₂-C₂₀ heteroaryl and n is valence of the metal ion. In examples of the present application, this class of dopants is represented by compound D3

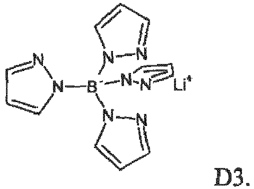

### V. ADVANTAGEOUS EFFECT OF THE INVENTION

The favourable effects of the inventive electrically doped semiconducting materials are shown in comparison with comparative devices comprising instead of the inventive combination of electron transporting matrices and dopants other combinations of matrices and dopants known in the art. The used devices are described in detail in examples.

In the first screening phase, there were in device of example1 tested 32 matrix compounds with 5 wt% Mg as dopant. Electron transport matrices comprising phosphine oxide matrices and having their LUMO level expressed in terms of their reduction potential vs. Fc⁺/Fc (measured by cyclic voltammetry in THF) higher than compound D0 (-2.21 V under standardized conditions used) performed better than C1 and C2, in terms of operational voltage and/or quantum efficiency of the device, and significantly better than matrices lacking the phosphine oxide group, irrespective of their LUMO level. These observations were confirmed also for several other divalent metals, namely Ca, Sr, Ba, Sm and Yb.

Nevertheless, for matrix compounds comprising at least one phenylene group as a spacer between the phosphine oxide group and the conjugated system of pi-electrons which has the most significant contribution the LUMO energy level of the molecule, it is advantageous that if the doping metal has the sum of the first and second ionization potential lower than 20 eV, the redox potential of the matrix compound measured by cyclic voltammetry is more negative than the redox potential of 4,7-diphenyl-1,10-phenanthroline measured under the same conditions.

More preferably, for the doping metal having the sum of the first and second ionization potential lower than 20 eV, the redox potential of the matrix compound measured by cyclic voltammetry is more negative than the redox potential of 9-phenyl-9H-carbazole-2,7-diyl)bis(diphenylphosphine oxide (E1) measured under the same conditions.

The results are summarized in Table 1, wherein relative change of voltage and efficiency (both measured at current density 10 mA/cm²) is calculated against the C2/Mg system of previous art taken as the reference. The overall score is calculated by subtraction of relative voltage change from relative change of efficiency.

**Table 1a**

| ETL matrix | ETL dopant | wt% dopant | U (V) | (U-U_{ref})/ U_{ref} (%) | EQE (%) | (EQE-EQE_{ref})/ EQE_{ref} **(%)** | score |
|---|---|---|---|---|---|---|---|
| E1 | Mg | 5 | 3.2 | -40 | 5.15 | -9 | +31 |
| E1 | Ca | 1 | 3.497 | -35 | 5.415 | -4 | +31 |
| E1 | Ca | 5 | 3.633 | -32 | 5.235 | -7 | +25 |
| E1 | Ba | 1 | 3.577 | -33 | 6.090 | +8 | +41 |
| E1 | Ba | 5 | 3.491 | -35 | 5.560 | -1 | +34 |
| E2 | Mg | 5 | 3.56 | -34 | 5.33 | -5 | +29 |
| E2 | Ca | 1 | 3.245 | -39 | 5.750 | +2 | +41 |
| E2 | Ca | 5 | 3.83 | -29 | 5.83 | +4 | +33 |
| E2 | Ba | 1 | 6.104 | +13 | 6.245 | +14 | +1 |
| E2 | Ba | 5 | 3.293 | -39 | 6.055 | +8 | +47 |
| E3 | Mg | 5 | 3.68 | -31 | 4.68 | -17 | +14 |
| E4 | Mg | 5 | 3.6 | -33 | 3.9 | -31 | +2 |
| E4 | Ca | 2 | 3.490 | -35 | 5.900 | +5 | +40 |
| E4 | Ba | 2 | 4.020 | -25 | 6.150 | +9 | +34 |
| E4 | Sm | 2 | 3.806 | -29 | 5.600 | 0 | +29 |
| E4 | Yb | 2 | 3.844 | -28 | 5.390 | -4 | +24 |
| E5 | Mg | 5 | 3.29 | -29 | 5.45 | -3 | +26 |
| E6 | Mg | 5 | 3.53 | -34 | 7.73 | +38 | +72 |
| E6 | Ca | 2 | 3.350 | -37 | 5.650 | +0 | +37 |
| E6 | Ba | 2 | 3.710 | -31 | 6.320 | +12 | +43 |
| E6 | Sm | 2 | 3.429 | -36 | 6.040 | +7 | +43 |
| E6 | Yb | 2 | 3.427 | -36 | 5.965 | +6 | +42 |
| E7 | Mg | 5 | 5.2 | -3 | 6.48 | +15 | +18 |
| E8 | Mg | 5 | 3.36 | -37 | 5.6 | 0 | +37 |
| E8 | Ca | 2 | 3.26 | -39 | 5.24 | -7 | +32 |
| E8 | Ba | 2 | 3.329 | 38 | 5.990 | +6 | +44 |
| E9 | Mg | 5 | 4.51 | -16 | 7.5 | +33 | +49 |
| E10 | Mg | 5 | 3.81 | -29 | 4.7 | -17 | +12 |
| E11 | Mg | 5 | 3.88 | -28 | 4.53 | -20 | +8 |
| E11 | Sr | 1 | 3.642 | -32 | 5.500 | -2 | +30 |
| E11 | Sr | 3 | 3.653 | -32 | 5.075 | -10 | +22 |
| E11 | Sm | 2 | 4.113 | -23 | 5.365 | -5 | +18 |
| E11 | Sm | 5 | 4.067 | -24 | 4.435 | -21 | +3 |
| E11 | Yb | 2 | 3.693 | -31 | 5.485 | -3 | +28 |
| E11 | Yb | 5 | 3.796 | -29 | 5.105 | -9 | +20 |

**Table 1b (continuation of Table 1a)**

| ETL matrix | ETL dopant | wt% dopant | U (V) | (U-U_{ref})/ U_{ref} (%) | EQE (%) | (EQE-EQE_{ref})/ EQE_{ref} **(%)** | score |
|---|---|---|---|---|---|---|---|
| B6 | Mg | 5 | 3.44 | -36 | 4.00 | -29 | +7 |
| B2 | Mg | 5 | 5.67 | +5 | 0.66 | -89 | -94 |
| B4 | Ca | 2 | 7.549 | +40 | 0.49 | -92 | -132 |
| B4 | Ba | 2 | 9.784 | +82 | 2.260 | -60 | -142 |
| 84 | Sm | 2 | 7.993 | +48 | 1.400 | -75 | -123 |
| B4 | Yb | 2 | 8.689 | +65 | 1.960 | -65 | -130 |
| C1 | Mg | 5 | 4.2 | -22 | 2.6 | -54 | -32 |
| C2 | Mg | 5 | 5.4 | 0 | 5.6 | 0 | 0 |
| C3 | Mg | 5 | 7.11 | +32 | 0.85 | -85 | -117 |
| C4 | Mg | 5 | 8.3 | +54 | 2.32 | -59 | -114 |
| C5 | Mg | 5 | 6.8 | +26 | 2.9 | -49 | -75 |
| C6 | Mg | 5 | 8.78 | +63 | 3.78 | -33 | -96 |
| C6 | Ca | 2 | 5.500 | +2 | 4.045 | -28 | -30 |
| C6 | Ba | 2 | 7.101 | +32 | 3.865 | -31 | -63 |
| C6 | Sm | 2 | 8.167 | +52 | 2.355 | -58 | -110 |
| C6 | Yb | 1 2 | 8.130 | +51 | 3.075 | -46 | -97 |
| C7 | Mg | 5 | 4.17 | -22 | 0.9 | -84 | -62 |
| C7 | Sm | 2 | 5.362 | 0 | 1.680 | -70 | -70 |
| C7 | Yb | 2 | 5.866 | +9 | 1.890 | -67 | -76 |
| C8 | Mg | 5 | 4.17 | -22 | 1.04 | -82 | -60 |
| C9 | Mg | 5 | 4.2 | -22 | 1 | -83 | -61 |
| D1 | Ca | 2 | 6.731 | +25 | 2.230 | -61 | -86 |
| D1 | Ba | 2 | 8.515 | +58 | 2.295 | -60 | -118 |
| D1 | Sm | 2 | 7.972 | +48 | 2.250 | -60 | -108 |
| D1 | Yb | 2 | 8.006 | +49 | 2.765 | -51 | -100 |

In the second phase of the research, various metals were tested in device 2 in matrices E1, E2 and C1, with two different ETL thicknesses 40 nm (U₁ and U₃) and 80 nm (U₂ and U₄) and with two different doping concentrations 5 wt% (U₁ and U₂) and 25 wt% (U₃ and U₄), all for current density 10 mA/cm².

The results summarized in Table 2 led to a surprising finding that metals that are able to form stable compounds in oxidation state II are especially appropriate for n-doping in phosphine oxide matrices despite their significantly lower reactivity and higher air stability in comparison with the least reactive alkali metal (Li). From the divalent metals tested, only zinc having extremely high sum of the first and second ionization potential failed as n-dopant, whereas aluminium with typical oxidation state III gave reasonably low operational voltages only if present in the doped ETL in the high 25 wt% concentration that afforded ETLs with impractically high light absorption. Transmittance assigned as "OD" that stands for "optical density" is reported in Table 2 only for 25 wt% doping concentration (OD₃ for layer thickness 40 nm and OD₄ for layer thickness 80 nm), as the measurements for lower doping concentrations suffered from bad reproducibility.

The typically trivalent bismuth failed as n-dopant completely, despite its ionization potential does not differ much, e.g. from manganese that showed, quite surprisingly, good doping action at least in E1.

Low values of differences U₁-U₂ and U₃-U₄ can be assigned to doped materials having high conductivity (voltage of the device depends only weakly on the thickness of the doped layer).

**Table 2a**

| ETL matrix | ETL dopant | U₁ (V) | U₂ (V) | U₁-U₂ (V) | U₃ (V) | U₄ (V) | U₃-U₄ (V) | OD₃ | OD₄ |
|---|---|---|---|---|---|---|---|---|---|
| E₁ | Li | 9.042 | >10 | na | 5.814 | 6.666 | 0.853 | 38 | 43 |
| E₁ | Na | 2.863 | 2.864 | 0.001 | 5.354 | 7.186 | 1.832 | 70 | 64 |
| E₁ | Mg | 2.954 | 2.970 | 0.016 | 2.965 | 2.960 | 0.005 | 62 | 33 |
| E₁ | Ca | 4.625 | 4.340 | -0.286 | 5.590 | 9.081 | 3.491 | 63 | 52 |
| E₁ | Sr | 3.650 | 3.700 | 0.050 | - | - | - | - | - |
| E₁ | Ba | 4.085 | 4.023 | -0.062 | 4.360 | 4.567 | 0.207 | 67 | 73 |
| E₁ | Sm | 3.138 | 3.136 | -0.002 | 7.889 | - | - | 63 | 61 |
| E₁ | Eu | - | - | - | 4.090 | 4.119 | 0.029 | - | - |
| E₁ | Yb | 3.022 | 3.032 | 0.009 | 5.578 | 6.932 | 1.354 | 66 | 68 |
| E₁ | Mn | 3.38 | 3.40 | 0.017 | - | - | - | - | - |
| E₁ | Zn | 6.124 | 8.842 | 2.718 | 5.592 | 7.545 | 1.954 | 65 | 76 |
| E₁ | Al | 7.614 | >10 | na | 3.321 | 3.301 | -0.020 | 48 | 31 |
| E₁ | Bi | 6.129 | 8.768 | 2.640 | 5.430 | 7.275 | 1.845 | 56 | 54 |
| E₂ | Li | 6.333 | 8.362 | 2.029 | 3.307 | 3.324 | 0.017 | 51 | 32 |
| E₂ | Na | 3.735 | 4.533 | 0.798 | >10 | >10 | na | 65 | 38 |
| E₂ | Mg | 3.189 | 3.232 | 0.043 | 3.464 | 3.489 | 0.025 | 68 | 72 |
| E₂ | Ca | 4.426 | 4.503 | 0.078 | 3.911 | 4.501 | 0.590 | 64 | 50 |
| E₂ | Sr | 3.842 | 3.832 | -0.010 | - | - | - | - | - |
| E₂ | Ba | 2.929 | 2.935 | 0.006 | 3.397 | 3.397 | 0.000 | 74 | 71 |
| E₂ | Sm | 3.610 | 3.894 | 0.284 | 6.053 | 7.939 | 1.887 | 72 | 63 |
| E₂ | Eu | - | - | - | 4.516 | 4.838 | 0.322 | - | - |
| E₂ | Yb | 2.932 | 2.933 | 0.001 | 5.442 | 6.625 | 1.183 | 73 | 65 |
| E₂ | Mn | 6.02 | 8.09 | 0.99 | - | - | - | - | - |
| E₂ | Zn | 7.898 | >10 | na | 7.000 | >10 | na | 66 | 71 |
| E₂ | Al | 8.650 | >10 | na | 3.203 | 3.196 | -0.007 | 39 | 27 |
| E₂ | Bi | 7.814 | >10 | na | 7.173 | >10 | na | 64 | 61 |

**Table 2b (continuation of Table 2a)**

| ETL matrix | ETL dopant | U₁ (V) | U₂ (V) | U₁-U₂ (V) | U₃ (V) | U₄ (V) | U₃-U₄ (V) | OD₃ | OD₄ |
|---|---|---|---|---|---|---|---|---|---|
| C1 | Li | 6.997 | >10 | na | 6.209 | 8.314 | 2.105 | 72 | 48 |
| C1 | Na | - | - | - | 4.417 | 4.455 | 0.037 | 56 | 31 |
| C1 | Mg | 4.180 | 4.178 | -0.002 | 4.174 | 4.167 | -0.007 | 62 | 57 |
| C1 | Ca | 4.031 | 4.104 | 0.074 | 3.619 | 3.616 | -0.004 | 38 | 21 |
| C1 | Sr | 4.033 | 4.071 | 0.0038 | - | - | - | - | - |
| C1 | Ba | 3.916 | 3.909 | -0.006 | 3.969 | 4.605 | 0.636 | 63 | 39 |
| C1 | Sm | 4.208 | 4.207 | 0.000 | 4.106 | 4.104 | -0.002 | 63 | 48 |
| C1 | Eu | 3.972 | 3.984 | 0.012 | - | - | - | - | - |
| C1 | Yb | 4.017 | 4.167 | -0.003 | 4.148 | 4.173 | 0.025 | 33 | 29 |
| C1 | Mn | 4.27 | 4.26 | -0.01 | - | - | - | - | - |
| C1 | Zn | 5.084 | 7.758 | 2.674 | 4.699 | 6.402 | 1.703 | 57 | 50 |
| C1 | Al | 4.152 | 4.949 | 0.797 | 3.135 | 3.123 | -0.011 | 45 | 26 |
| C1 | Bi | 4.842 | 6.355 | 1.513 | 4.306 | 4.603 | 0.297 | 59 | 68 |

In matrices with deep LUMO, like C1, the operational voltage is often surprisingly higher than in devices comprising matrices with the LUMO levels in the range according to invention, despite good conductivity of many doped semiconducting materials based on C1. Apparently, the good conductivity of a semiconducting material is not a sufficient condition for low operational voltage of the device comprising it. Based on this finding, it is supposed that doped semiconducting materials according to this invention enable, besides the reasonable conductivity, also efficient charge injection from the doped layer in the adjacent layer.

In the third research phase, the observed effects were confirmed in OLEDs of example 3 comprising alternative emitter systems and further embodiments of the invention described in examples 4- 7 were implemented. The achieved results summarized in the Table 3 confirmed the surprising superiority of phosphine oxide ETL matrices having higher LUMO levels, despite these matrices should be more difficult to dope with the relatively weakly reducing metals used in the present invention in comparison with the phosphine oxide matrices of the previous art (like C1) which were thought to be dopable with Mg owing to their deeper LUMO and specific structure comprising the metal complexing unit.

This series of experiments confirmed that also with other emitters, the preferred matrix compounds like E1 and E2 of the present invention perform better than other phosphine oxide matrix compounds that do not fall within the scope described in the summary of invention, and much better in comparison with matrices lacking the phosphine oxide group.

The results showed that if combined with matrices defined in the summary of the invention, even substantially air stable metals, possessing moreover further technically advantageous features like good evaporability, can afford electrically doped semiconductive materials and devices that perform equally well or even better than devices available in the art.

**Table 3**

| LEL | ETL matrix | ETL dopant | wt% dopant | U (V) | (U-U_{ref})/ U_{ref} (%) | EQE (%) | (EQE-EQE_{ref})/ EQE_{ref} (%) | score |
|---|---|---|---|---|---|---|---|---|
| ABH-112/ NUBD-369 | E1 | Mg | 5 | 3.498 | -35 | 6.640 | +18 | +53 |
| | E2 | Mg | 5 | 3.751 | -30 | 5.975 | +6 | +36 |
| | C1 | Mg | 5 | 4.545 | -15 | 3.905 | -30 | -15 |
| | C10 | Mg | 5 | - | - | 0 | no light | - |
| Two - colour fluoresc. white* | E1 | Mg | 5 | 3.480 | -35 | 7.660 | +36 | +71 |
| | E2 | Mg | 5 | 3.83 | -29 | 6.67 | +19 | +48 |
| | C1 | Mg | 5 | 4.970 | -8 | 4.470 | -20 | -12 |
| | C10 | Mg | 5 | 6.950 | +28 | 0.820 | -85 | -113 |
| Spiro-Pye/ BCzVB | E1 | Mg | 5 | 3.331 | -38 | 6.19 | +10 | +48 |
| | E1 | Ca | 5 | 3.311 | -38 | 4.46 | -20 | +18 |
| | E1 | Ba | 12 | 3.087 | -42 | 3.44 | -39 | +3 |
| | E1 | Sm | 5 | 3.318 | -38 | 4.53 | -19 | +19 |
| | E2 | Mg | 5 | 3.480 | -35 | 6.08 | +8 | +43 |
| | E2 | Ca | 5 | 3.497 | -35 | 3.56 | -37 | +1 |
| | E2 | Ba | 5 | 3.090 | -42 | 3.59 | -36 | +6 |
| | C7 | Mg | 5 | 3.679 | -31 | 0.32 | -94 | -63 |
| | C7 | Ca | 5 | 3.647 | -33 | 0.52 | -90 | -57 |

| | | | | | | | | |
|---|---|---|---|---|---|---|---|---|
| * ABH-112/NUBD-369 + ABH-036/NRD129 (Sun Fine Chemicals) | | | | | | | | |

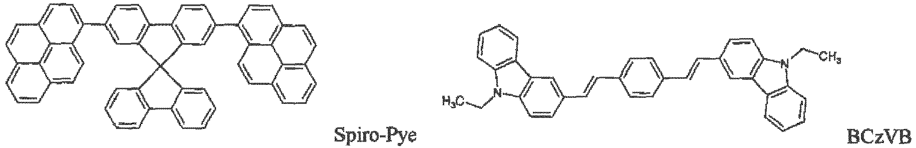

### I. EXAMPLES

### Auxiliary materials

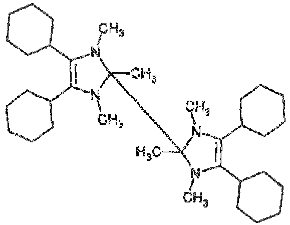

4,4',5,5'-tetracyclohexyl-1,1',2,2',3,3'-hexamethyl-2, 2',3,3'-tetrahydro-1H, 1'H-biimidazole, CAS 1253941-73-9, F1; 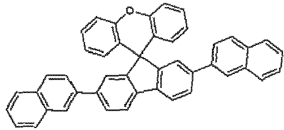 2,7-di(naphtalen-2-yl)spiro[fluorene-9,9'-xanthene], LUMO (CV vs. Fc⁺/Fc) -2.63 V, WO2013/149958, F2; 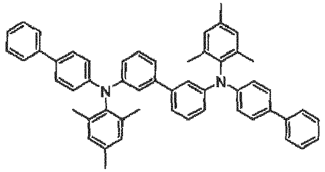 N3,N3'-di([1,1'-biphenyl]-4-yl)-N3,N3'-dimesityl-[1,1'-biphenyl]-3,3'-diamine, WO2014/060526, F3; 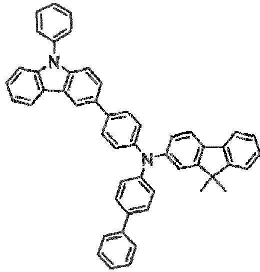 biphenyl-4-yl(9,9-diphenyl-9H-fluoren-2-yl)-[4-(9-phenyl-9H-carbazol-3-yl)phenyl]-amine, CAS 1242056-42-3, F4; 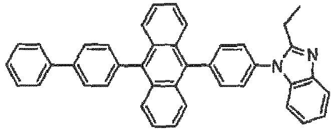 1-(4-(10-(([1,1'-biphenyl]-4-yl)anthracen-9-yl)phenyl)-2-ethyl-1H-benzo[d]imidazole, CAS 1254961-38-0, F5.

### Auxiliary procedures

### Cyclic voltammetry

The redox potentials given at particular compounds were measured in an argon deaerated, dry 0.1M THF solution of the tested substance, under argon atmosphere, with 0.1M tetrabutylammonium hexafluorophosphate supporting electrolyte, between platinum working electrodes and with an Ag/AgCl pseudo-standard electrode, consisting of a silver wire covered by silver chloride and immersed directly in the measured solution, with the scan rate 100 mV/s. The first run was done in the broadest range of the potential set on the working electrodes, and the range was then adjusted within subsequent runs appropriately. The final three runs were done with the addition of ferrocene (in 0.1M concentration) as the standard. The average of potentials corresponding to cathodic and anodic peak of the studied compound, after subtraction of the average of cathodic and anodic potentials observed for the standard Fc⁺/Fc redox couple, afforded finally the values reported above. All studied phosphine oxide compounds as well as the reported comparative compounds showed well-defined reversible electrochemical behaviour.

### Synthesis examples

The synthesis of phosphine oxide ETL matrix compounds is well described in many publications, besides the literature cited at particular compounds listed above and describing typical multistep procedures used for these compounds, the compound E6 was prepared, according to Bull. Chem. Soc. Jpn., 76, 1233-1244 (2003), quite specifically by an anionic rearrangement of the compound E2.

For the new compounds, however, the typical procedures were used, as exemplified below specifically for the compounds E5 and E8. All synthesis steps were carried out under argon atmosphere. Commercial materials were used without additional purification. Solvents were dried by appropriate means and deaerated by saturation with argon.

### Synthesis example 1

### [1,1':4',1"-terphenyl]-3,5-diylbis-diphenylphosphine oxide E5

### Step 1: 3,5-dibromo-1,1':4',1"-terphenyl

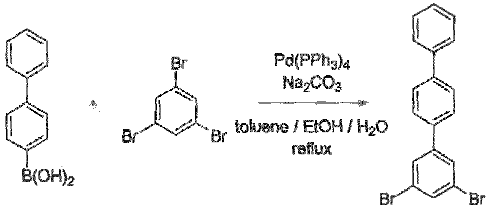

All components (10.00 g (1.0 eq, 50.50 mmol) [1,1'-biphenyl]-4-yl-boronic acid, 23.85 g (1.5 eq, 75.75 mmol) 1,3,5-tribromobenzene, 1.17 g (2.0 mol%, 1.01 mmol) tetrakis(triphenyl phosphine)palladium(0), 10.70 g (2 eq, 101 mmol) sodium carbonate in 50 mL water, 100 mL ethanol and 310 mL toluene) were mixed together and stirred at reflux for 21 hours. The reaction mixture was cooled to room temperature and diluted with 200 mL toluene (three layers appear). The aqueous layer was extracted with 100 mL toluene, the combined organic layers were washed with 200 mL water, dried and evaporated to dryness. The crude material was purified via column chromatography (SiO₂, hexane/DCM 4:1 v/v) The combined fractions were evaporated, suspended in hexane and filtered off to give 9.4 g of a white glittering solid (yield 48 %, HPLC purity 99.79 %).

### Step 2: [1,1':4',1"-terphenyl]-3,5-diylbis-diphenylphosphine oxide

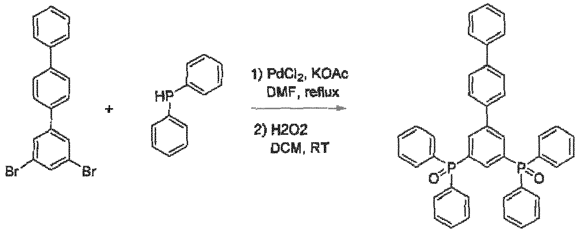

All components (5.00 g (1.0 eq, 12.9 mmol) 3,5-dibromo-1,1':4',1"-terphenyl from the previous step, 12.0 g (5.0 eq, 64.4 mmol) diphenyl phosphine, 114 mg (5 mol%, 6.44 x 10^{- 4} mol) palladium(II) chloride, 3.79 g (3.0 eq, 38.6 mmol) potassium acetate and 100 mL N,N-dimethylformamide) were mixed together and stirred at reflux for 21 hours. Then the reaction mixture was cooled to room temperature; water was added (100 mL) and the mixture was stirred for 30 min, then filtered off. The solid was re-dissolved in DCM (100 mL), H₂O₂ (30 wt% aqueous solution) was added dropwise, and the solution was stirred overnight at room temperature. Then the organic layer was decanted, washed with water (100 mL) twice, dried over MgSO₄, and evaporated to dryness. The resulting oil was triturated in hot MeOH (100 mL) which induced the formation of a solid. After filtration hot, the resulting solid was rinsed with MeOH and dried, yielding 9.7 g of crude product. The crude material was re-dissolved in DCM and chromatographed on a short silica column, elution with ethyl acetate. After evaporation of the eluate to dryness, the resulting solid was triturated in hot MeOH (100 mL), followed by trituration in hot ethyl acetate (50 mL). After drying, the desired compound was obtained in 70 % yield (5.71 g). Finally, the product was purified using vacuum sublimation.

The pure sublimed compound was amorphous, with no detectable melting peak on the DSC curve, glass transition onset at 86 °C, and started to decompose at 490 °C.

### Synthesis example 2

### (9,9-dihexyl-9H-fluorene-2,7-diyl)bis-diphenylphosphine oxide E8

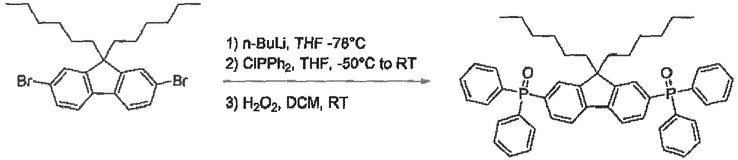

2,7-Dibromo-9,9-dihexylfluorene (5.00 g, 1.0 eq, 10.2 mmol) was placed in a flask and deaerated with argon. Then anhydrous THF (70 mL) was added, and the mixture was cooled to -78 °C. 9.7 mL (2.5M solution in hexanes, 2.4 eq, 24.4 mmol) n-butyllithium were then added dropwise; the resulting solution was stirred for 1 h at -78 °C, and then progressively warmed to -50 °C. After slow addition of pure chlorodiphenylphosphine (4.0 mL, 2.2 eq, 22.4 mmol), the mixture was left to stir overnight till room temperature. MeOH (20 mL) was added to quench the reaction, and the solution was evaporated to dryness. The solid was re-dissolved in DCM (50 mL), H₂O₂ (30 wt% aqueous solution, 15 mL) was added dropwise, and the mixture left under stirring. After 24 h, the organic phase was separated, washed subsequently with water and brine, dried over MgSO₄, and evaporated to dryness. Purification by chromatography (silica, gradient elution from hexane / EtOAc 1:1 v/v to neat EtOAc) provided the desired compound in 34 % yield (2.51 g). The material was then further purified by vacuum sublimation.

The pure sublimed compound was amorphous, with no detectable melting peak on the DSC curve, and decomposed at 485 °C.

### Device examples

### Example 1 (blue OLED)

A first blue emitting device was made by depositing a 40 nm layer of HTM2 doped with PD2 (matrix to dopant weight ratio of 97:3 wt%) onto an ITO-glass substrate, followed by a 90 nm undoped layer of HTM1. Subsequently, a blue fluorescent emitting layer of ABH113 (Sun Fine Chemicals) doped with NUBD370 (Sun Fine Chemicals) (97:3 wt%) was deposited with a thickness of 20 nm. A 36 nm layer of the tested inventive or comparative compound was deposited on the emitting layer together with the desired amount of the metallic element (usually, with 5 wt% Mg) as ETL. Subsequently, an aluminium layer with a thickness of 100 nm was deposited as a cathode.

The observed voltages and quantum efficiencies at a current density 10 mA/cm² are reported in the Table 1.

### Example 2 (organic diode)

A similar device was produced as in Example 1, with the difference that the emitter was omitted, and each combination matrix-dopant was tested in two different thicknesses of the ETL (40 and 80 nm) and with two different dopant concentrations (5 and 25 wt%). The observed voltages at the current density 10 mA/cm² and, wherever measured, optical absorbances of the device, are reported in the Table 2.

### Example 3 (blue or white OLED)

A similar device was produced as in Example 1, with the difference that there were combined various compositions of the inventive and comparative semiconducting materials in the ETL with various emitter systems. The results were evaluated similarly as in Example 1 and are summarized in Table 3.

### Example 4 (blue OLED)

In device of Example 1, Al cathode was replaced with the sputtered indium tin oxide (ITO) cathode in combination with the Mg or Ba doped ETL. The results showed that the inventive technical solution is applicable also in top emitting OLEDs with cathode made of transparent semiconductive oxide.

### Example 5 (transparent OLED)

In transparent devices having p-side (substrate with ITO anode, HTL, EBL) as in Example 1, and sputtered 100 nm thick ITO cathode as in Example 4, polymeric emitting layer comprising blue emitting polymer (supplied by Cambridge Display Technology) was successfully tested. The results reported in Table 4 (together with the n-side composition of the device, which in all cases comprised a 20 nm thick HBL consisting of F2 and ETL1 consisting of E2 and D3 in weight ratio 7:3 and having a thickness given in the table) show that inventive ETLs are applicable even with polymeric LELs having very high LUMO levels about -2.8 V (in terms of their redox potential vs. Fc⁺/Fc reference). Without metal doped ETL, the devices had (at current density 10 mA/cm²) very high voltages, even when EILs made of pure metal were deposited under the ITO electrode.

**Table 4**

| ETL1 (nm) | ETL2 (30 nm) | EIL | U (V) | EQE (%) | CIE1931x | CIE1931y |
|---|---|---|---|---|---|---|
| 20 | E2/Mg 8:2 | 5 nm Mg-Ag (9:1) | 4.2 | 1.6 | 0.16 | 0.11 |
| 10 | E2/Mg 9:1 | 5 nm Ba | 4.5 | 1.3 | 0.16 | 0.13 |
| 20 | E2/Mg 8:2 | 5 nm Al | 5.4 | 1.1 | 0.16 | 0.14 |
| 5 | E2/Ba 8:2 | - | 4.6 | 1.3 | 0.16 | 0.18 |
| 20 | - | 5 nm Mg-Ag (9:1) | 7.5 | 1.8 | 0.17 | 0.22 |
| 10 | - | 5 nm Ba | 6.4 | 2.2 | 0.10 | 0.13 |

### Example 6 (metal deposition using linear vaporization source)

Evaporation behaviour of Mg in a linear evaporation source was tested. It was demonstrated that Mg can be deposited from linear sources with the rate as high as 1 nm/s without spitting, whereas point evaporation sources spit Mg particles at the same deposition rate significantly.

### Example 7 (metal + metal salt electrical doping in the same ETL)

Mixed ETL comprising a matrix combined with LiQ + either Mg or W₂(hpp)₄ a combined two-component doping system showed the superiority of the salt + metal combination.

### Example 8 (tandem white OLED)

On an ITO substrate, following layers were deposited by vacuum thermal evaporation:
10 nm thick HTL consisting of 92 wt% auxiliary material F4 doped with 8 wt% PD2, 135 nm thick layer of neat F4, 25 nm thick blue emitting layer ABH113 (Sun Fine Chemicals) doped with NUBD370 (Sun Fine Chemicals) (97:3 wt%), 20 nm thick layer ABH036 (Sun Fine Chemicals), 10 nm thick CGL consisting of 95 wt% inventive compound E12 doped with 5 wt% Mg, 10 nm thick HTL consisting of 90 wt% auxiliary material F4 doped with 10 wt% PD2, 30 nm thick layer of neat F4, 15 nm thick layer of neat F3, 30 nm thick proprietary phosphorescent yellow emitting layer, 35 nm thick ETL of auxiliary material F5, 1 nm thick LiF layer and aluminium cathode. The diode operated at 6.81 V had EQE 24.4 %.

### Example 9 (tandem white OLED)

The example 8 was repeated with Yb in the CGL instead of Mg. The diode operated at 6.80 V had EQE 23.9 %.

### Example 10 (tandem white OLED)

The example 9 was repeated with compound E6 instead of E12 in the CGL. The diode operated at 6.71 V had EQE 23.7 %.

The features disclosed in the foregoing description, in the claims and in the accompanying drawings may both separately and in any combination be material for realizing the claimed invention in diverse forms thereof. Reference values of physico-chemical properties relevant for the present invention (first and second ionization potential, normal boiling point, standard redox potential) are summarized in Table 5.

**Table 5**

| Element | Iₚ^{I} eV ² | Iₚ^{II} eV ² | ∑ Iₚ^{I-II} eV ² | b.p.¹ °C | E⁰ V |
|---|---|---|---|---|---|
| Li | 5.391 | 75.640 | 81.031 | 1330 | -3.04 |
| Na | 5.139 | 47.286 | 52.425 | 890 | -2.713 |
| Mg | 7.646 | 15.035 | 22.681 | 1110 | -2.372 |
| Al | 5.986 | 18.829 | 24.815 | 2470 | -1.676 |
| Ca | 6.113 | 11.872 | 17.985 | 1487 | -2.84 |
| Mn | 7.434 | 15.640 | 23.074 | 2100 | -1.18 |
| Zn | 9.394 | 17.964 | 27.358 | 907 | -0.793 |
| Sr | 5.695 | 11.030 | 16.725 | 1380 | -2.89 |
| Ba | 5.212 | 10.004 | 15.216 | 1637 | -2.92 |
| Sm | 5.644 | 11.07 | 16.714 | 1900 | ** |
| Eu | 5.670 | 11.241 | 16.911 | 1440 | -1.99 |
| Yb | 6.254 | 12.176 | 18.430 | 1430 | -2.22 |
| Bi | 7.286 | 16.69 | 23.976 | 1560 | 0.317 |

| | | | | | |
|---|---|---|---|---|---|
| ¹Yiming Zhang, Julian R. G. Evans, Shoufeng Yang: Corrected Values for Boiling Points and Enthalpies of Vaporization of Elements in Handbooks. From: Journal of Chemical & Engineering Data. 56, 2011, p. 328-337; the values fit with values given in articles for individual elements in current German version of Wikipedia. ² http://en.wikipedia.org/wiki/lonization_energies_of_the_elements_%28data_page%29 | | | | | |

### Used abbreviations

- CGL: charge generating layer
- CV: cyclic voltammetry
- DCM: dichloromethane
- DSC: differential scanning calorimetry
- EIL: electron injecting layer
- EQE: external quantum efficiency of electroluminescence
- ETL: electron transporting layer
- ETM: electron transport matrix
- EtOAc: ethyl acetate
- Fc⁺/Fc: ferrocenium/ferrocene reference system
- h: hour
- HIL: hole injecting layer
- HOMO: highest occupied molecular orbital
- HTL: hole transporting layer
- HTM: hole transport matrix
- ITO: indium tin oxide
- LUMO: lowest unoccupied molecular orbital
- LEL: light emitting layer
- LiQ: lithium 8-hydroxyquinolinolate
- MeOH: methanol
- mol%: molar percent
- OLED: organic light emitting diode
- QA: quality assurance
- RT: room temperature
- THF: tetrahydrofuran
- UV: ultraviolet (light)
- vol%: volume percent
- v/v: volume/volume (ratio)
- VTE: vacuum thermal evaporation
- wt%: weight (mass) percent

## Claims

1. Electrically doped semiconducting material comprising at least one metallic element in its elemental form as n-dopant and at least one electron transport matrix compound comprising at least one phosphine oxide group, wherein the metallic element is selected from elements that form in their oxidation number II at least one stable compound and the electron transport matrix compound has the reduction potential, when measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, more preferably lower than 2,4,7,9-tetraphenyl-1,10-phenanthroline, even more preferably lower than 9,10-di(naphthalen-2-yl)-2-phenylanthracene, most preferably lower than 2,9-bis(2-methoxyphenyl)-4,7-diphenyl-1,10-phenanthroline, still preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than N4,N4'-di(naphthalen-1-yl)-N4,N4'-diphenyl-[1,1'-biphenyl]-4,4'-diamine, even more preferably higher than 4,4'-di(9H-carbazol-9-yl)-1,1'-biphenyl, most preferably higher than bis(4-(9H-carbazol-9-yl)phenyl)(phenyl)phosphine oxide, less but still preferably higher than 3-([1,1'-biphenyl]-4-yl)-5-(4-(tert-butyl)phenyl)-4-phenyl-4H-1,2,4-triazole and even less but still preferably higher than pyrene, wherein it is provided that the metallic element is not zinc.

2. Electrically doped semiconducting material according to claim 1, wherein the electron transport matrix compound is a compound according to formula (I): 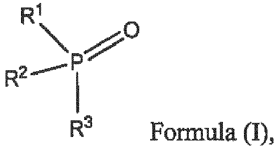 wherein R¹, R² and R³ are independently selected from C₁-C₃₀-alkyl, C₃-C₃₀-cycloalkyl, C₂-C₃₀-heteroalkyl, C₆-C₃₀-aryl, C₂-C₃₀-heteroaryl, C₁-C₃₀-alkoxy, C₃-C₃₀-cycloalkyloxy, C₆-C₃₀-aryloxy, wherein each of the substituents R¹, R² and R³ optionally comprises further phosphine oxide groups and at least one of the substituents R¹, R² and R³ comprises a conjugated system of at least 10 delocalized electrons.

3. Electrically doped semiconducting material according to claims 1 or 2, wherein the metallic element has a sum of its first and second ionization potential lower than 25 eV, preferably lower than 24 eV, more preferably lower than 23.5 eV, most preferably lower than 23.1 eV.

4. Electrically doped semiconducting material according to any of claims 2-3, wherein the conjugated system of at least 10 delocalized electrons is attached directly to the phosphine oxide group.

5. Electrically doped semiconducting material according to claim 2 or 3, wherein the conjugated system of at least 10 delocalized electrons is separated from the phosphine oxide group by a spacer group A.

6. Electrically doped semiconducting material according to claim 5, wherein the spacer group A is a divalent six-membered aromatic carbocyclic or heterocyclic group.

7. Electrically doped semiconducting material according to claim 6, wherein the spacer A is selected from phenylene, azine-2,4-diyl, azine-2,5-diyl, azine-2,6-diyl, 1,3-diazine-2,4-diyl and 1,3-diazine-2,5-diyl.

8. Electrically doped semiconducting material according to any of claims 2-7, wherein the conjugated system of at least 10 delocalized electrons is a C₁₄-C₅₀-aryl or a C₈-C₅₀ heteroaryl.

9. Electrically doped semiconducting material according to any of claims 1-8, further comprising a metal salt additive consisting of at least one metal cation and at least one anion.

10. Electrically doped semiconducting material according to claim 9, wherein the metal cation is Li⁺ or Mg²⁺

11. Electrically doped semiconducting material according to claim 9 or 10, wherein the metal salt additive is selected from metal complexes comprising a 5-, 6- or 7-membered ring that contains a nitrogen atom and an oxygen atom attached to the metal cation and from complexes having the structure according to formula (II) 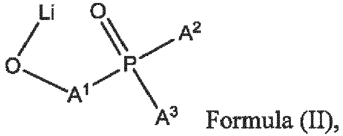 wherein A¹ is a C₆-C₃₀ arylene or C₂-C₃₀ heteroarylene comprising at least one atom selected from O, S and N in an aromatic ring and each of A² and A³ is independently selected from a C₆-C₃₀ aryl and C₂-C₃₀ heteroaryl comprising at least one atom selected from O, S and N in an aromatic ring.

12. Electrically doped semiconducting material according to any of claims 9-11, wherein the anion is selected from the group consisting of phenolate substituted with a phosphine oxide group, 8-hydroxyquinolinolate and pyrazolylborate.

13. Process for manufacturing the semiconducting material defined in any of claims 1-12, comprising a step where the electron transport matrix compound comprising at least one phosphine oxide group and the metallic element selected from elements that form in their oxidation number II at least one stable compound are coevaporated and codeposited under reduced pressure,
wherein the electron transport matrix compound has a reduction potential, when measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, more preferably lower than 2,4,7,9-tetraphenyl-1,10-phenanthroline, even more preferably lower than 9,10-di(naphthalen-2-yl)-2-phenylanthracene, most preferably lower than 2,9-bis(2-methoxyphenyl)-4,7-diphenyl-1,10-phenanthroline, still preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than 4,4'-di(9H-carbazol-9-yl)-1,1'-biphenyl, even more preferably higher than bis(4-(9H-carbazol-9-yl)phenyl)(phenyl)phosphine oxide, most preferably higher than 3-([1,1'-biphenyl]-4-yl)-5-(4-(tert-butyl)phenyl)-4-phenyl-4H-1,2,4-triazole.

14. Process according to claim 13, wherein the metallic element is selected from Mg, Ca, Sr, Ba, Yb, Sm, Eu and Mn.

15. Process according to claim 13 or 14, wherein the metallic element has normal boiling point lower than 3000 °C, preferably lower than 2200 °C, more preferably lower than 1800 °C, most preferably lower than 1500°C.

16. Process according to any of claims 13-15, wherein the metallic element has a sum of its first and second ionization potential higher than 16 eV, preferably higher than 17 eV, more preferably higher than 18 eV, even more preferably higher than 20 eV, most preferably higher than 21 eV, less but still preferably higher than 22 eV and even less but still preferably higher than 23 eV.

17. Process according to any of claims 13-16, wherein the metallic element is substantially air stable.

18. Process according to any of claims 13-17, wherein the metallic element is evaporated from a linear evaporation source.

19. Electronic device comprising a cathode, an anode and the electrically doped semiconducting material according to any of claims 1-12 between the cathode and anode.

20. Electronic device according to claim 19, further comprising a light emitting layer between the cathode and anode.

21. Electronic device according to claim 19 or 20, wherein the electrically doped semiconducting material is comprised in an electron transporting or electron injecting layer.

22. Electronic device according to claim 21, wherein the electron transporting or electron injecting layer is thicker than 5 nm, preferably thicker than 10 nm, more preferably thicker than 15 nm, even more preferably thicker than 20 nm and most preferably thicker than 25 nm.

23. Electronic device according to claim 21 or 22, wherein the electron transporting layer comprises a first compartment closer to the light emitting layer and a second compartment closer to the cathode, the first and second compartment differing in their composition.

24. Electronic device according to claim 23, wherein the first compartment consists of a first electron transporting matrix.

25. Electronic device according to claim 23, wherein the first compartment comprises the first electron transporting matrix and a metal salt additive consisting of at least one metal cation and at least one anion.

26. Electronic device according to claim 25, wherein the first compartment consists of the first electron transporting matrix and the metal salt additive and the second compartment consists of the electrically doped semiconducting material according to any of claims 1-13 and 20.

27. Electronic device according to claim 26, wherein the second compartment consists of a second electron transport matrix and the metallic element in its elemental form.

28. Electronic device according to any of claims 24-27, wherein the first compartment is thinner than 50 nm, preferably thinner than 40 nm, more preferably thinner than 30 nm, even more preferably thinner than 20 nm, most preferably thinner than 15 nm, also preferably thinner than 10 nm and less but still preferably thinner than 5 nm.

29. Electronic device according to any of claims 21-28, wherein the electron transporting or electron injecting layer is adjacent to the light emitting layer consisting of compounds that have their reduction potentials, if measured by cyclic voltammetry under the same conditions, more negative than the electron transport matrix compounds of the adjacent electron transporting or electron injecting layer.

30. Electronic device according to any of claims 21-29, wherein the electron transporting or electron injecting layer is adjacent to a cathode consisting of a semiconducting metal oxide.

31. Electronic device according to claim 30, wherein the semiconducting metal oxide is indium tin oxide.

32. Electronic device according to any of claims 20-31, wherein the light emitting layer emits blue or white light.

33. Electronic device according to any of claims 20-32, wherein the light emitting layer comprises at least one polymer.

34. Electronic device according to claim 33, wherein the polymer is a blue light emitting polymer.

## Patentansprüche

1. Elektrisch dotiertes halbleitendes Material, umfassend zumindest ein metallisches Element in seiner elementaren Form als einen n-Dotanden und zumindest eine Elektronentransportmatrixverbindung, umfassend zumindest eine Phosphinoxidgruppe, wobei das metallische Element ausgewählt ist aus Elementen, die in ihrer Oxidationsstufe II zumindest eine stabile Verbindung bilden, und die Elektronentransportmatrix ein Redoxpotential hat, das, wenn dieses mittels Cyclovoltammetrie unter gleichen Bedingungen gemessen wird, geringer ist als das von Tris(2-benzo[d]thiazol-2-yl)phenoxyaluminium, bevorzugt geringer als das von 9,9',10,10'-Tetraphenyl-2,2'-bianthracen oder 2,9-Di([1,1'-biphenyl]-4-yl)-4,7-diphenyl-1,10-phenanthrolin, bevorzugter geringer als das von 2,4,7,9-Tetraphenyl-1,10-phenanthrolin, noch bevorzugter geringer als das von 9,10-Di(naphthalen-2-yl)-2-phenylanthracen, am meisten bevorzugt geringer als das von 2,9-Bis(2-methoxyphenyl)-4,7-diphenyl-1,10-phenanthrolin, noch bevorzugter geringer als das von 9,9'-Spirobi[fluoren]-2,7-diylbis(diphenylphosphinoxid), und höher als das von N2,N2,N2',N2',N7,N7,N7',N7'-Octaphenyl-9,9'-spirobi[fluoren]-2,2',7,7'-tetraamin, bevorzugt höher als das von Triphenylen, bevorzugter höher als das von N4,N4'-Di(naphthalen-1-yl)-N4,N4'-diphenyl-[1,1'-biphenyl]-4,4'-diamin, noch bevor-zugter höher als das von 4,4'-Di(9H-carbazol-9-yl)-1,1'-biphenyl, am meisten bevorzugt höher als das von Bis(4-(9H-carbazol-9-yl)phenyl)(phenyl)-phosphinoxid, weniger, aber dennoch vorzugsweise höher als das von 3-([1,1'-Biphenyl]-4-yl)-5-(4-(tert-butyl)phenyl)-4-phenyl-4H-1,2,4-triazol und noch weniger, aber dennoch vorzugsweise höher als das von Pyren, wobei vorausgesetzt ist, dass das metallische Element nicht Zink ist.

2. Elektrisch dotiertes halbleitendes Material nach Anspruch 1, wobei die Elektronentransportmatrixverbindung eine Verbindung der Formel (I) ist: 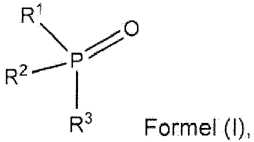 wobei R¹, R² und R³ unabhängig ausgewählt sind aus C₁-C₃₀-Alkyl, C₃-C₃₀-Cycloalkyl, C₂-C₃₀-Heteroalkyl, C₆-C₃₀-Aryl, C₂-C₃₀-Heteroaryl, C₁-C₃₀-Alkoxy, C₃-C₃₀-Cycloalkyloxy, C₆-C₃₀-Aryloxy, wobei jeder der Substituenten R¹, R² und R³ optional weitere Phosphinoxidgruppen umfasst und zumindest einer der Substituenten R¹, R² und R³ ein konjugiertes System von zumindest 10 delokalisierten Elektronen umfasst.

3. Elektrisch dotiertes halbleitendes Material nach den Ansprüchen 1 oder 2, wobei das metallische Element eine Summe seines ersten und zweiten Ionisationspotentials hat, die geringer ist als 25 eV, bevorzugt geringer als 24 eV, darüber hinaus bevorzugt geringer als 23,5 eV, am meisten bevorzugt geringer als 23,1 eV.

4. Elektrisch dotiertes halbleitendes Material nach einem der Ansprüche 2 bis 3, wobei das konjugierte System von zumindest 10 delokalisierten Elektronen direkt mit der Phosphinoxidgruppe verbunden ist.

5. Elektrisch dotiertes halbleitendes Material nach Anspruch 2 oder 3, wobei das konjugierte System der zumindest 10 delokalisierten Elektronen von der Phosphinoxidgruppe durch eine Abstandshaltergruppe A getrennt ist.

6. Elektrisch dotiertes halbleitendes Material nach Anspruch 5, wobei die Abstandshaltergruppe A eine divalente sechsgliedrige aromatische carbozyklische oder heterozyklische Gruppe ist.

7. Elektrisch dotiertes halbleitendes Material nach Anspruch 6, wobei der Abstandshalter A ausgewählt ist aus Phenylen, Azin-2,4-diyl, Azin-2,5-diyl, Azin-2,6-diyl, 1,3-Diazin-2,4-diyl und 1,3-Diazin-2,5-diyl.

8. Elektrisch dotiertes halbleitendes Material nach einem der Ansprüche 2 bis 7, wobei das konjugierte System von zumindest 10 delokalisierten Elektronen ein C₁₄-C₅₀-Aryl oder ein C₈-C₅₀-Heteroaryl ist.

9. Elektrisch dotiertes halbleitendes Material nach einem der Ansprüche 1 bis 8, ferner umfassend ein Metallsalzadditiv, bestehend aus einem Metallkation und zumindest einem Anion.

10. Elektrisch dotiertes halbleitendes Material nach Anspruch 9, wobei das Metallkation Li⁺ oder Mg²⁺ ist.

11. Elektrisch dotiertes halbleitendes Material nach Anspruch 9 oder 10, wobei das Metallsalzadditiv ausgewählt ist aus Metallkomplexen, umfassend einen 5-, 6- oder 7-gliedrigen Ring, der ein Stickstoffatom und ein Sauerstoffatom, das mit dem Metallkation verbunden ist, und aus Komplexen mit der folgenden Formel (II) 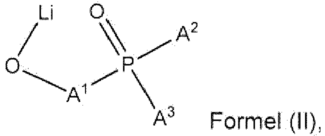 wobei A¹ ein C₆-C₃₀-Arylen oder C₂-C₃₀-Heteroarylen ist, umfassend zumindest ein Atom ausgewählt aus O, S und N in einem aromatische Ring und jedes der A² und A³ unabhängig ausgewählt ist aus einem C₆-C₃₀-Aryl und C₂-C₃₀-Heteroaryl umfassend zumindest ein Atom ausgewählt aus O, S und N in einem aromatischen Ring.

12. Elektrisch dotiertes halbleitendes Material nach einem der Ansprüche 9 bis 11, wobei das Anion ausgewählt ist aus der Gruppe, bestehend aus Phenolat, das mit einer Phosphinoxidgruppe substituiert ist, 8-Hydroxychinolinolat und Pyrazolylborat.

13. Verfahren zum Herstellen des halbleitenden Materials, wie in einem der Ansprüche 1 bis 12 definiert, umfassend einen Schritt, in dem die Elektronentransportmatrixverbindung, umfassend zumindest eine Phosphinoxidgruppe, und das metallische Element ausgewählt aus Elementen, die in ihrer Oxidationsstufe II zumindest eine stabile Verbindung bilden, unter reduziertem Druck coverdampft und coabgeschieden werden,
wobei die Elektronentransportmatrixverbindung ein Redoxpotential hat, das, wenn dieses mittels Cyclovoltammetrie unter gleichen Bedingungen gemessen wird, geringer ist als das von Tris(2-benzo[d]thiazol-2-yl)phenoxyaluminium, bevorzugt geringer als das von 9,9',10,10'-Tetraphenyl-2,2'-bianthracen oder 2,9-Di([1,1-biphenyl]-4-yl)-4,7-diphenyl-1,10-phenanthrolin, bevorzugter geringer als das von 2,4,7,9-Tetraphenyl-1,10-phenanthrolin, noch bevorzugter geringer als das von 9,10-Di(naphthalen-2-yl)-2-phenylanthracen, am meisten bevorzugt geringer als das von 2,9-Bis(2-methoxyphenyl)-4,7-diphenyl-1,10-phenanthrolin, noch bevorzugter geringer als das von 9,9'-Spirobi[fluoren]-2,7-diylbis(diphenylphosphinoxid), und höher als das von N2,N2,N2',N2',N7,N7,N7',N7'-Octaphenyl-9,9'-spirobi[fluoren]-2,2',7,7'-tetraamin, bevorzugt höher als das von Triphenylen, bevorzugter höher als das von N4,N4'-Di(naphthalen-1-yl)-N4,N4'-diphenyl-[1,1'-biphenyl]-4,4'-diamin, noch bevor-zugter höher als das von 4,4'-Di(9H-carbazol-9-yl)-1,1'-biphenyl, am meisten bevorzugt höher als das von Bis(4-(9H-carbazol-9-yl)phenyl)(phenyl)phosphinoxid, weniger, aber dennoch vorzugsweise höher als das von 3-([1,1'-Biphenyl]-4-yl)-5-(4-(tert-butyl)phenyl)-4-phenyl-4H-1,2,4-triazol.

14. Verfahren nach Anspruch 13, wobei das metallische Element ausgewählt ist aus Mg, Ca, Sr, Ba, Yb, Sm, Eu und Mn.

15. Verfahren nach Anspruch 13 oder 14, wobei das metallische Element einen normalen Siedepunkt von weniger als 3000°C, vorzugsweise weniger als 2200°C, darüber hinaus bevorzugt weniger als 1800°C, am meisten bevorzugt weniger als 1500°C hat.

16. Verfahren nach einem der Ansprüche 13 bis 15, wobei das metallische Element eine Summe seines ersten und zweiten lonisationspotentials von mehr als 16 eV, vorzugsweise mehr als 17 eV, vorzugsweise mehr als 18 eV, darüber hinaus bevorzugt mehr als 20 eV, am meisten bevorzugt mehr als 21 eV, weniger, aber dennoch bevorzugt mehr als 22 eV und etwas weniger, aber immer noch bevorzugt mehr als 23 eV hat.

17. Verfahren nach einem der Ansprüche 13 bis 16, wobei das metallische Element im Wesentlichen luftstabil ist.

18. Verfahren nach einem der Ansprüche 13 bis 17, wobei das metallische Element aus einer linearen Verdampfungsquelle verdampft wird.

19. Elektronische Vorrichtung, umfassend eine Kathode, eine Anode und das elektrisch dotierte halbleitende Material nach einem der Ansprüche 1 bis 12 zwischen der Kathode und der Anode.

20. Elektronische Vorrichtung nach Anspruch 19, ferner umfassend eine lichtemittierende Schicht zwischen der Kathode und der Anode.

21. Elektronische Vorrichtung nach Anspruch 19 oder 20, wobei das elektrisch dotierte halbleitende Material in einer Elektronentransportschicht oder einer Elektroneninjektionsschicht umfasst ist.

22. Elektronische Vorrichtung nach Anspruch 21, wobei die Elektronentransportschicht oder die Elektroneninjektionsschicht dicker ist als 5 nm, vorzugsweise dicker als 10 nm, bevorzugter dicker als 15 nm, noch bevorzugter dicker als 20 nm und am bevorzugtesten dicker als 25 nm.

23. Elektronische Vorrichtung nach Anspruch 21 oder 22, wobei die Elektronentransportschicht einen ersten Abschnitt, näher an der lichtemittierenden Schicht, und einen zweiten Abschnitt, näher an der Kathode, umfasst, wobei sich der erste und der zweite Abschnitt in ihrer Zusammensetzung unterscheiden.

24. Elektronische Vorrichtung nach Anspruch 23, wobei der erste Abschnitt aus einer ersten Elektronentransportmatrix besteht.

25. Elektronische Vorrichtung nach Anspruch 23, wobei der erste Abschnitt die erste Elektronentransportmatrix und ein Metallsalzadditiv umfasst, bestehend aus zumindest einem Metallkation und zumindest einem Anion.

26. Elektronische Vorrichtung nach Anspruch 25, wobei der erste Abschnitt aus der ersten Elektronentransportmatrix und dem Metalisalzadditiv besteht und der zweite Abschnitt aus dem elektrisch dotierten halbleitenden Material gemäß einem der Ansprüche 1 bis 13 und 20 besteht.

27. Elektronische Vorrichtung nach Anspruch 26, wobei der zweite Abschnitt aus einer zweiten Elektronentransportmatrix und dem metallischen Element in seiner elementaren Form besteht.

28. Elektronische Vorrichtung nach einem der Ansprüche 24 bis 27, wobei der erste Abschnitt dünner ist als 50 nm, vorzugsweise dünner als 40 nm, bevorzugter dünner als 30 nm, noch bevorzugter dünner als 20 nm, am meisten bevorzugt dünner als 15 nm, vorzugsweise auch dünner als 10 nm und weniger, aber vorzugsweise dünner als 5 nm.

29. Elektronische Vorrichtung nach einem der Ansprüche 21 bis 28, wobei die Elektronentransportschicht oder Elektroneninjektionsschicht benachbart zu der lichtemittierenden Schicht, bestehend aus Verbindungen, die Redoxpotentiale haben, die, wenn unter gleichen Bedingungen mittels Cyclovoltammetrie gemessen, negativer sind als die der Elektronentransportmatrixverbindungen der benachbarten Elektronentransportschicht oder Elektroneninjektions-schicht, ist.

30. Elektronische Vorrichtung nach einem der Ansprüche 21 bis 29, wobei die Elektronentransportschicht oder Elektroneninjektionsschicht benachbart zu einer Kathode ist, bestehend aus einem halbleitenden Metalloxid.

31. Elektronische Vorrichtung nach Anspruch 30, wobei das halbleitende Metalloxid Indium-Zinn-Oxid ist.

32. Elektronische Vorrichtung nach einem der Ansprüche 20 bis 31, wobei die lichtemittierende Schicht blaues oder weißes Licht emittiert.

33. Elektronische Vorrichtung nach einem der Ansprüche 20 bis 32, wobei die lichtemittierende Schicht zumindest ein Polymer umfasst.

34. Elektronische Vorrichtung nach Anspruch 33, wobei das Polymer ein Polymer ist, das blaues Licht emittiert.

## Revendications

1. Matériau semi-conducteur électriquement dopé comprenant au moins un élément métallique dans sa forme élémentaire en tant que dopant n et au moins un composé de matrice de transport d'électrons comprenant au moins un groupe oxyde de phosphine, dans lequel l'élément métallique est choisi parmi des éléments qui forment au moins un composé stable dans leur nombre d'oxydation de II et le composé de matrice de transport d'électrons voit son potentiel de réduction, lorsqu'il est mesuré par voltamétrie cyclique dans les mêmes conditions, inférieur au tris(2-benzo[d]thiazol-2-yl)phénoxyaluminium, plus préférablement inférieur au 9,9',10,10'-tétraphényl-2,2'-bianthracène ou à la 2,9-di([1,1'-biphényl]-4-yl)-4,7-diphényl-1,10-phénanthroline, le plus préférablement inférieur à la 2,4,7,9-tétraphényl-1,10-phénanthroline, encore plus préférablement inférieur au 9,10-di(naphtalèn-2-yl)-2-phénylanthracène, toujours plus préférablement inférieur à la 2,9-bis(2-méthoxyphényl)-4,7-diphényl-1,10-phénanthroline, encore et toujours plus préférablement inférieur à l'oxyde de 9,9'-spirobi[fluorène]-2,7-diylbis(diphénylphospine), et supérieur à la N2,N2,N2',N2',N7,N7,N7',N7'-octaphényl-9,9'spirobi[fluorène]-2,2',7,7'-tétraamine, préférablement supérieur au triphénylène, plus préférablement supérieur à la N4,N4'-di(naphtalèn-1-yl)-N4,N4'-diphényl-[1,1'-biphényl]4,4'-diamine, encore plus préférablement supérieur au 4,4'-di(9H-carbozol-9-yl)-1,1'-biphényle, bien plus préférablement supérieur à l'oxyde de bis(4-9H-carbazol-9-yl)phényl(phényl)phosphine, moindre mais encore préférablement supérieur au 3-([1,1'-biphényl]-4-yl)-5-(4-(tert-butyl)phényl-4H-1,2,4-triazole et et même moindre mais encore préférablement supérieur au pyrène, dans lequel il est prévu que l'élément métallique ne soit pas le zinc.

2. Matériau semi-conducteur électriquement dopé selon la revendication 1, dans lequel le composé de matrice de transport d'électrons est un composé répondant à la formule (I) : 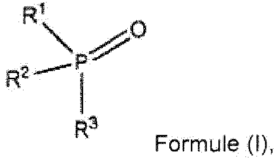 dans laquelle R¹, R² et R³ sont indépendamment choisis parmi un alkyle en C₁-C₃₀, un cycloalkyle en C₃-C₃₀, un hétéroalkyle en C₂-C₃₀, un aryle en C₆-C₃₀, un hétéroaryle en C₂-C₃₀, un alcoxy en C₁-C₃₀, un cycloalcoxy en C₃-C₃₀, un aryloxy en C₆-C₃₀, dans lequel chacun des substituants R¹, R² et R³ comprend en outre des groupes oxyde de phosphine et au moins un des substituants R¹, R² et R³ comprend un système conjugué constitué d'au moins 10 électrons délocalisés.

3. Matériau semi-conducteur électriquement dopé selon la revendication 1 ou la revendication 2, dans lequel les éléments métalliques voient une somme de leurs premier et second potentiels d'ionisation inférieure à 25 eV, de préférence inférieure à 24 eV, plus préférablement inférieure à 23,5 eV, le plus préférablement inférieur à 23,1 eV.

4. Matériau semi-conducteur électriquement dopé selon l'une quelconque des revendications 2 à 3, dans lequel le système conjugué constitué d'au moins 10 électrons délocalisés est directement attaché au groupe oxyde de phosphine.

5. Matériau semi-conducteur électriquement dopé selon la revendication 2 ou la revendication 3, dans lequel le système conjugué constitué d'au moins 10 électrons délocalisés est séparé du groupe oxyde de phosphine par un groupe espaceur A.

6. Matériau semi-conducteur électriquement dopé selon la revendication 5, dans lequel le groupe espaceur A est un groupe divalent carbocyclique ou hétérocyclique aromatique à six chaînons.

7. Matériau semi-conducteur électriquement dopé selon la revendication 6, dans lequel l'espaceur A est choisi parmi le phénylène, l'azine-2,4-diyle, l'azine-2,5-diyle, l'azine-2,6-diyle, le 1,3-diazine-2,4-diyle et le 1,3-diazine-2,5-diyle.

8. Matériau semi-conducteur électriquement dopé selon l'une quelconque des revendications 2 à 7, dans lequel le système conjugué constitué d'au moins 10 électrons délocalisés est un aryle en C₁₄-C₅₀ ou un hétéroaryle en C₈-C₅₀.

9. Matériau semi-conducteur électriquement dopé selon l'une quelconque des revendications 1 à 8, comprenant en outre un additif de sel de métal constitué d'au moins un cation métallique et d'au moins un anion.

10. Matériau semi-conducteur électriquement dopé selon la revendication 9, dans lequel les cations métalliques sont Li⁺ ou Mg²⁺.

11. Matériau semi-conducteur électriquement dopé selon la revendication 9 ou la revendication 10, dans lequel l'additif de sel de métal est choisi parmi des complexes de métal comprenant un cycle à 5, 6 ou 7 chaînons qui contiennent un atome d'azote et un atome d'oxygène attaché au cation métallique et parmi des complexes ayant la structure répondant à la formule (II) 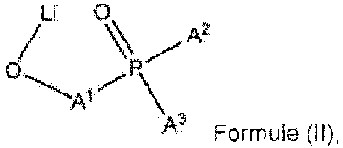 dans laquelle A¹ représente un arylène en C₆-C₃₀ ou un hétéroarylène en C₂-C₃₀ comprenant au moins un atome choisi parmi O, S et N dans un noyau aromatique et chacun de A² et de A³ est indépendamment choisi parmi un aryle en C₆-C₃₀ ou un hétéroaryle en C₂-C₃₀ comprenant au moins un atome choisi parmi O, S et N dans un noyau aromatique.

12. Matériau semi-conducteur électriquement dopé selon l'une quelconque des revendications 9 à 11, dans lequel l'anion est choisi dans le groupe constitué du phénolate substitué par un groupe oxyde de phosphine, du 8-hydroxyquinolinolate et du pyrazolylborate.

13. Processus de fabrication du matériau semi-conducteur défini dans l'une quelconque des revendications 1 à 12, comprenant une étape dans laquelle le composé de matrice de transport d'électrons comprenant au moins un groupe oxyde de phosphine et l'élément métallique choisi parmi des éléments qui forment au moins un composé stable dans leur nombre d'oxydation de II sont co-évaporés et co-déposés sous une pression réduite,
dans lequel le composé de matrice de transport d'électrons voit son potentiel de réduction, lorsqu'il est mesuré par voltamétrie cyclique dans les mêmes conditions, inférieur au tris(2-benzo[d]thiazol-2-yl)phénoxyaluminium, plus préférablement inférieur au 9,9',10,10'-tétraphényl-2,2'-bianthracène ou à la 2,9-di([1,1'-biphényl]-4-yl)-4,7-diphényl-1,10-phénanthroline, le plus préférablement inférieur à la 2,4,7,9-tétraphényl-1,10-phénanthroline, encore plus préférablement inférieur au 9,10-di(naphtalèn-2-yl)-2-phénylanthracène, toujours plus préférablement inférieur à la 2,9-bis(2-méthoxyphényl)-4,7-diphényl-1,10-phénanthroline, encore et toujours plus préférablement inférieur à l'oxyde de 9,9'-spirobi[fluorène]-2,7-diylbis(diphénylphospine), et supérieur à la N2,N2,N2',N2',N7,N7,N7',N7'-octaphényl-9,9'-spirobi[fluorène]-2,2',7,7'-tétraamine, préférablement supérieur au triphénylène, plus préférablement supérieur à la N4,N4'-di(naphtalèn-1-yl)-N4,N4'-diphényl-[1,1'-biphényl]4,4'-diamine, encore plus préférablement supérieur au 4,4'-di(9H-carbozol-9-yl)-1,1'-biphényle, bien plus préférablement supérieur à l'oxyde de bis(4-9H-carbazol-9-yl)phényl(phényl)phosphine, moindre mais encore préférablement supérieur au 3-([1,1'-biphényl]-4-yl)-5-(4-(tert-butyl)phényl-4H-1,2,4-triazole.

14. Processus selon la revendication 13, dans lequel l'élément métallique est choisi parmi Mg, Ca, Sr, Ba, Yb, Sm, Eu et Mn.

15. Processus selon la revendication 13 ou la revendication 14, dans lequel l'élément métallique voit son point d'ébullition normal inférieur à 3 000 °C, de préférence inférieur à 2 200 °C, plus préférablement inférieur à 1 800 °C, le plus préférablement inférieur à 1 500 °C.

16. Processus selon l'une quelconque des revendications 13 à 15, dans lequel l'élément métallique voit une somme de ses premier et second potentiels d'ionisation supérieure à 16 eV, de préférence supérieure à 17 eV, plus préférablement supérieure à 18 eV, encore plus préférablement supérieure à 20 eV, le plus préférablement supérieure à 21 eV, moindre mais encore plus préférablement supérieure à 22 eV et même moindre mais encore plus préférablement supérieure à 23 eV.

17. Processus selon l'une quelconque des revendications 13 à 16, dans lequel l'élément métallique est essentiellement de l'air stable.

18. Processus selon l'une quelconque des revendications 13 à 17, dans lequel l'élément métallique est évaporé à partir d'une source d'évaporation linéaire.

19. Dispositif électronique comprenant une cathode, une anode et le matériau semi-conducteur électriquement dopé selon l'une quelconque des revendications 1 à 12 situé entre la cathode et l'anode.

20. Dispositif électronique selon la revendication 19, comprenant en outre une couche électroluminescente située entre la cathode et l'anode.

21. Dispositif électronique selon la revendication 19 ou la revendication 20, dans lequel le matériau semi-conducteur électriquement dopé est compris dans une couche de transport d'électrons ou d'injection d'électrons.

22. Dispositif électronique selon la revendication 21, dans lequel la couche de transport d'électrons ou d'injection d'électrons est plus épaisse que 5 nm, de préférence plus épaisse que 10 nm, plus préférablement plus épaisse que 15 nm, même plus préférablement plus épaisse que 20 nm et le plus préférablement plus épaisse que 25 nm.

23. Dispositif électronique selon la revendication 21 ou la revendication 22, dans lequel la couche de transport d'électrons comprend un premier compartiment plus près de la couche électroluminescente et un second compartiment plus près de la cathode, les premier et second compartiments étant différents en termes de leur composition.

24. Dispositif électronique selon la revendication 23, dans lequel le premier compartiment est constitué d'une première matrice de transport d'électrons.

25. Dispositif électronique selon la revendication 23, dans lequel le premier compartiment comprend la première matrice de transport d'électrons et un additif de sel de métal constitué d'au moins un cation métallique et d'au moins un anion.

26. Dispositif électronique selon la revendication 25, dans lequel le premier compartiment est constitué de la première matrice de transport d'électrons et de l'additif de sel de métal, et le second compartiment est constitué du matériau semi-conducteur électriquement dopé selon l'une quelconque des revendications 1 à 13 et la revendication 20.

27. Dispositif électronique selon la revendication 26, dans lequel le second compartiment est constitué d'une seconde matrice de transport d'électrons et de l'élément métallique dans sa forme élémentaire.

28. Dispositif électronique selon l'une quelconque des revendications 24 à 27, dans lequel le premier compartiment est plus mince que 50 nm, de préférence plus mince que 40 nm, plus préférablement plus mince que 30 nm, encore plus préférablement plus mince que 20 nm, le plus préférablement plus mince que 15 nm, également de préférence plus mince que 10 nm et moindre mais encore plus préférablement plus mince que 5 nm.

29. Dispositif électronique selon l'une quelconque des revendications 21 à 28, dans lequel la couche de transport d'électrons ou d'injection d'électrons est adjacente à la couche électroluminescente constituée de composés qui voient leur potentiel de réduction, s'ils sont mesurés par voltamétrie cyclique dans les mêmes conditions, plus négatifs que pour les composés de matrice de transport d'électrons de la couche de transport d'électrons ou d'injection d'électrons adjacente.

30. Dispositif électronique selon l'une quelconque des revendications 21 à 29, dans lequel la couche de transport d'électrons ou d'injection d'électrons est adjacente à une cathode constituée d'un oxyde métallique semi-conducteur.

31. Dispositif électronique selon la revendication 30, dans lequel l'oxyde métallique semi-conducteur est l'oxyde d'indium et d'étain.

32. Dispositif électronique selon l'une quelconque des revendications 20 à 31, dans lequel la couche électroluminescente émet de la lumière bleue ou blanche.

33. Dispositif électronique selon l'une quelconque des revendications 20 à 32, dans lequel la couche électroluminescente comprend au moins un polymère.

34. Dispositif électronique selon la revendication 33, dans lequel le polymère est un polymère émettant de la lumière bleue.
